# EUROPEAN PATENT APPLICATION

(11) **EP 2 230 278 A2**
(43) Date of publication of application: **22.09.2010**
(21) Application number: 10002577.4
(22) Date of filing: 11.03.2010
(51) Int. Cl.: C09B 33/12, G02B 5/22, G03F 7/04

(54) **Color composition for color filter, method for preparing it, and color filter**

(30) Priority: 11.03.2009 JP 2009058714
(71) Applicant: FUJIFILM Corporation, Tokyo (JP)
(72) Inventor: Tateishi, Keiichi, Fujinomiya-shi, Shizuoka (JP); Hayashi, Shinya, Fujinomiya-shi, Shizuoka (JP)
(74) Representative: HOFFMANN EITLE

(57) **Abstract**

A color composition for color filter is provided, the color composition for color filter including: at least one of an azo pigment represented by formula (1), a tautomer of the azo pigment, and salts or hydrates thereof: 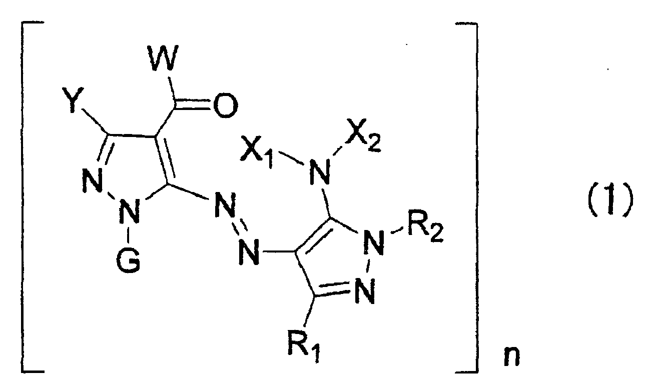 wherein Y represents a hydrogen atom or a substituent; W represents an alkoxy group, an amino group, an alkyl group or an aryl group; G represents a hydrogen atom, an alkyl group, a cycloalkyl group, an aralkyl group, an alkenyl group, an alkynyl group, an aryl group or a heterocyclic group; X₁ and X₂ each independently represents a hydrogen atom, an alkyl group, an acyl group, an alkylsulfonyl group or an arylsulfonyl group; R₁ represents a hydrogen atom or a substituent; R₂ represents a heterocyclic group; and n represents an integer of from 1 to 4.

## Description

### BACKGROUND OF THE INVENTION

### 1. Field of the Invention

The present invention relates to a color composition for color filter useful as a colorant for color filter, a method for producing it, and a color filter.

### 2. Description of the Related Art

Down-sized, flat-screen, lightweight, large-panel and high-definition image display devices are required these days. Their applications have expanded into personal computer displays, TV sets, game machines and others, for which the demand for color liquid-crystal displays is rapidly increasing.

In that background, color filters for use in liquid-crystal display devices have become required to have high color purity.

As color filters to be formed on solid-state imaging devices or liquid-crystal display devices for making them display color images, there are known a color filter comprising a yellow filter layer, a magenta filter layer and a cyan filter layer formed adjacent to each other on the same face of a substrate, and a color filter composed of a red filter layer, a green filter layer and a blue filter layer.

These days color filters are required to have further higher definition. However, conventional pigment dispersions could not attain high resolution and have a problem in that coarse pigment particles may cause color unevenness, and therefore, they are unsuitable to applications such as solid-state imaging devices that require fine patterns. To solve the problems, heretofore, use of dye has been proposed (for example, see JP-A 6-75375).

It is known to use a yellow dye in the yellow filter array of a color filter (for example, see JP-A 2003-277662).

However, the color pattern with dye is insufficient in heat resistance and lightfastness, and therefore a color filter with an organic pigment excellent in heat resistance and lightfastness is investigated.

Regarding a method for producing a color filter with an organic pigment, for example, there is known a photolithographic method comprising exposing a composition of an organic pigment dispersed in a photosensitive resin, to light and developing it for patterning in which the patterning step is repeated for desired times (for example, see JP-A 1-152449). There are mentioned various printing methods of offset printing, inkjet printing or the like with ink containing an organic pigment.

As the organic pigment for color filer, use of organic pigments excellent in heat resistance and lightfastness, such as anthraquinone pigments, diketopyrrolopyrole pigments, quinacridone pigments, isoindoline pigments, perinone pigments, perylene pigments and condensed azo pigments is investigated. However, these pigments have a problem in that they are generally difficult to disperse in color filters and therefore color filters of high transparency are difficult to obtain.

Similarly, also in a color filter comprising a yellow filter layer, a magenta filter layer and a cyan filter layer, the yellow dye to be used in the yellow filter layer is required to be further improved in point of the fastness thereof.

Japanese Patent 4073453 describes a dye having excellent fastness to light, heat and ozone.

### SUMMARY OF THE INVENTION

An object of the invention is to provide a color composition for color filter having a good color hue, capable of exhibiting good fastness to light, heat and ozone, having good dispersibility, having high transparency and excellent in spectral characteristics, contrast and dispersion temporal stability, and to provide a method for preparing it.

Another object of the invention is to provide a color filter to be obtained by the use of the above-mentioned color composition for color filter, which has high transparency and is excellent in spectral characteristics, contrast and dispersion temporal stability.

The present inventors have assiduously studied and, as a result, have found that a specific nitrogen-containing heterocyclic azo pigment can solve the above-mentioned problems.

Concrete means for solving the above-mentioned problems are mentioned below.
(1) A color composition for color filter, including:
   at least one of an azo pigment represented by formula (1), a tautomer of the azo pigment, and salts or hydrates thereof: 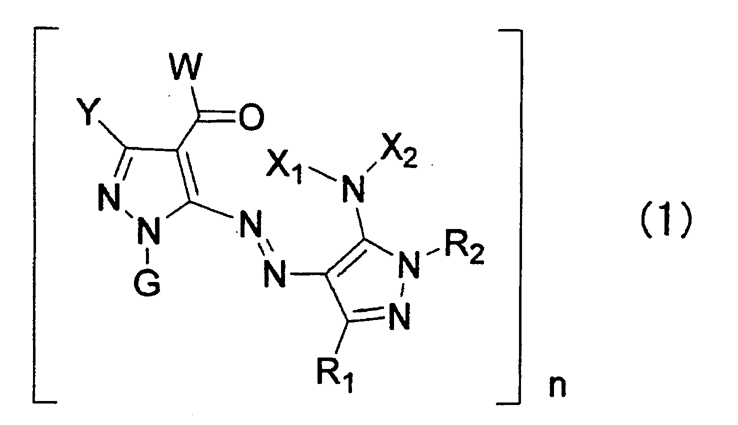
   wherein Y represents a hydrogen atom or a substituent; W represents an alkoxy group, an amino group, an alkyl group or an aryl group;
   G represents a hydrogen atom, an alkyl group, a cycloalkyl group, an aralkyl group, an alkenyl group, an alkynyl group, an aryl group or a heterocyclic group;
   X₁ and X₂ each independently represents a hydrogen atom, an alkyl group, an acyl group, an alkylsulfonyl group or an arylsulfonyl group;
   R₁ represents a hydrogen atom or a substituent;
   R₂ represents a heterocyclic group;
   n represents an integer of from 1 to 4; and
   when n = 2, the formula (1) represents a dimer via G, W, X₁, X₂, R₁ or R₂; when n = 3, the formula (1) represents a trimer via G, W, X₁, X₂, R₁ or R₂; and when n = 4, the formula (1) represents a tetramer via G, W, X₁, X₂, R₁ or R₂.
(2) The color composition for color filter as described in (1),
   wherein n in the formula (1) is 2.
(3) The color composition for color filter as described in (1) or (2),
   wherein at least one of X₁ and X₂ in the formula (1) is a hydrogen atom.
(4) The color composition for color filter as described in any of (1) to (3),
   wherein the azo pigment represented by the formula (1) is an azo pigment represented by formula (2): 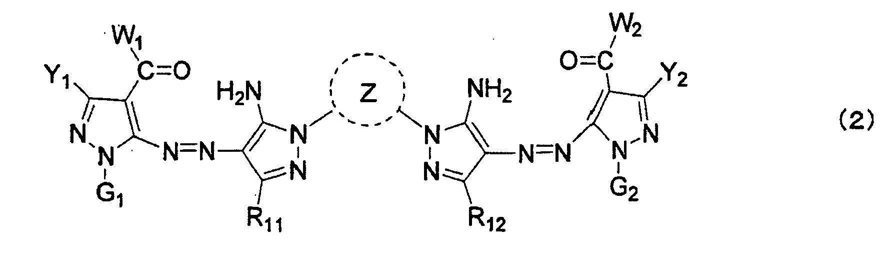 wherein Z represents a 5- to 8-membered nitrogen-containing hetero ring;
   Y₁, Y₂, R₁₁ and R₁₂ each independently represents a hydrogen atom or a substituent;
   G₁ and G₂ each independently represents a hydrogen atom, a cycloalkyl group, an alkyl group, an aralkyl group, an alkenyl group, an alkynyl group, an aryl group or a heterocyclic group;
   W₁ and W₂ each independently represents an alkoxy group, an amino group, an alkyl group or an aryl group.
(5) The color composition for color filter as described in any of (1) to (4),
   wherein W, W₁ and W₂ each independently represents an alkoxy group having a total carbon number of at most 3, an amino group, or an alkylamino group having a total carbon number of at most 3.
(6) The color composition for color filter as described in any of (1) to (5),
   wherein G, G₁ and G₂ each independently represents an alkyl group having a total carbon number of at most 3.
(7) The color composition for color filter as described in any of (4) to (6),
   wherein Z is a 6-membered nitrogen-containing hetero ring.
(8) The color composition for color filter as described in any of (1) to (4),
   wherein the azo pigment represented by the formula (1) or formula (2) is an azo pigment represented by formula (3): 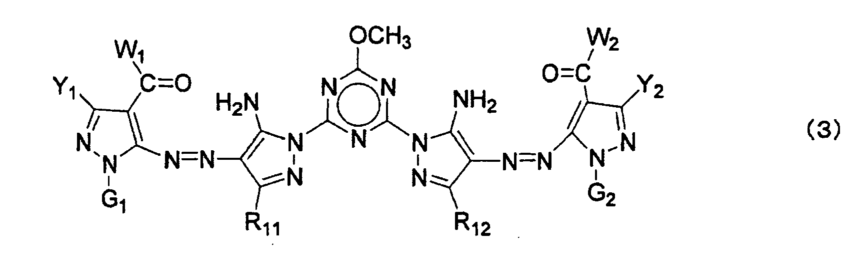 wherein Y₁, Y₁, R₁₁ and R₁₂ each independently represents a hydrogen atom or a substituent;
   G1 and G2 each independently represents a hydrogen atom, a cycloalkyl group, an alkyl group, an aralkyl group, an alkenyl group, an alkynyl group, an aryl group or a heterocyclic group;
   W₁ and W₂ each independently represents an alkoxy group, an amino group, an alkyl group or an aryl group.
(9) The color composition for color filter as described in any of (1) to (8),
   wherein the azo pigment represented by the formula (1), formula (2) or formula (3) is an azo pigment which has a crystalline morphology and which is represented by formula (4): 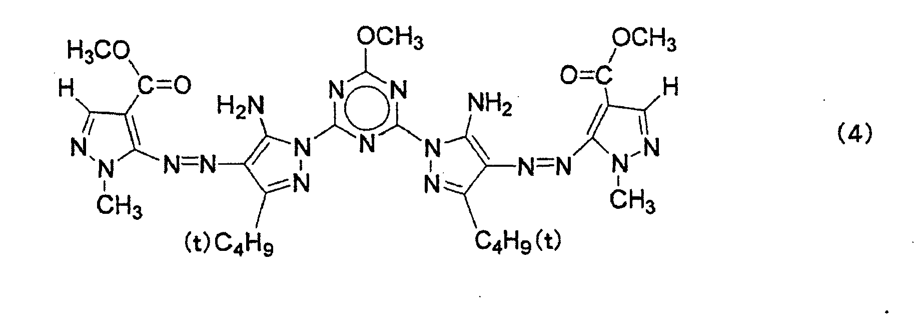
(10) The color composition for color filter as described in (9), which includes a colorant selected from the group consisting of the azo pigment represented by the formula (4) and tautomers thereof,
   wherein the colorant shows characteristic X-ray diffraction peaks at Bragg angles (2θ ± 0.2°) of 7.2° and 25.9° in CuKα characteristic X-ray diffractometry.
(11) The color composition for color filter as described in any of (1) to (10), further including:
   a polymerizable compound; and
   a solvent.
(12) The color composition for color filter as described in (11), which contains the azo pigment represented by the formula (1) in an amount of from 0.01 to 2 parts by mass relative to 1 part by mass of the polymerizable compound.
(13) The color composition for color filter as described in (11) or (12),
   wherein the polymerizable compound is a photosensitive compound.
(14) The color composition for color filter as described in any of (1) to (13), further including:
   one or more dispersants selected from a surfactant, a silicone-type additive, a pigment-type additive, a silane coupling agent and a titanium coupling agent.
(15) A color filter formed by using the color composition for color filter as described in any of (1) to (14).
(16) The color filer a as described in (15), which is formed by a photolithographic method or an inkjet method.
(17) A method for preparing a color composition for color filter as described in (14), the method including:
   a step of obtaining a pigment dispersion by dispersing one or more dispersants selected from a surfactant, a silicone-type additive, a pigment-type additive, a silane coupling agent and a titanium coupling agent, and an azo pigment represented by formula (1) in a part of a solvent; and
   a step of mixing the pigment dispersion with a polymerizable compound and a remainder of the solvent.

### BRIEF DESCRIPTION OF THE DRAWINGS

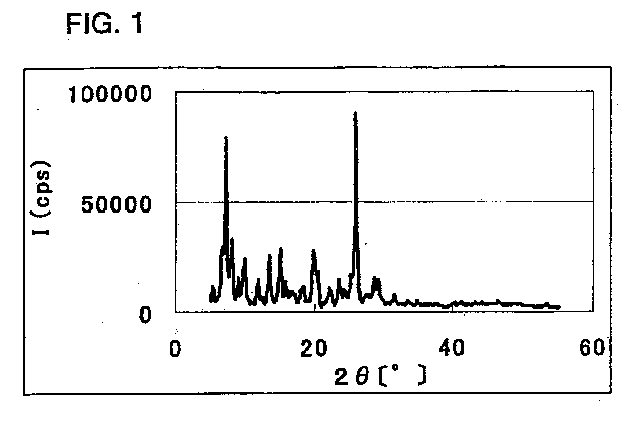

Fig. 1 is an X-ray diffraction pattern of the azo pigment (1) produced according to Production Example 1.

### DETAILED DESCRIPTION OF THE INVENTION

### [Color Composition for Color Filter]

The color composition for color filter of the invention contains at least one of an azo pigment of formula (1), its tautomer, and their salts or hydrates.

The aliphatic group, the aryl group, the heterocyclic group and the substituent in the invention are described.

In the aliphatic group in the invention, the aliphatic site may be any of a linear, branched or cyclic one. It may be saturated or unsaturated. Concretely, for example, it includes an alkyl group, an alkenyl group, a cycloalkyl group, a cycloalkenyl group, etc. The aliphatic group may be unsubstituted or may have a substituent.

The aryl group may be a single ring or a condensed ring. It may be unsubstituted or may have a substituent. In the heterocyclic group, the heterocyclic site may be any one having a hetero atom (for example, nitrogen atom, sulfur atom, oxygen atom) in the ring, and may be a saturated ring or an unsaturated ring. It may be a single ring or a condensed ring, and may be unsubstituted or may have a substituent.

The substituent in the invention may be any substitutable group, including, for example, an aliphatic group, an aryl group, a heterocyclic group, an acyl group, an acyloxy group, an acylamino group, an aliphatic oxy group, an aryloxy group, a heterocyclic oxy group, an aliphatic oxycarbonyl group, an aryloxycarbonyl group, a heterocyclic oxycarbonyl group, a carbamoyl group, an aliphatic sulfonyl group, an arylsulfonyl group, a heterocyclic sulfonyl group, an aliphatic sulfonyloxy group, an arylsulfonyloxy group, a heterocyclic sulfonyloxy group, a sulfamoyl group, an aliphatic sulfonamide group, an arylsulfonamide group, a heterocyclic sulfonamide group, an amino group, an aliphatic amino group, an arylamino group, a heterocyclic amino group, an aliphatic oxycarbonylamino group, an aryloxycarbonylamino group, a heterocyclic oxycarbonylamino group, an aliphatic sulfinyl group, an arylsulfinyl group, an aliphatic thio group, an arylthio group, a hydroxy group, a cyano group, a sulfo group, a carboxy group, an aliphatic oxyamino group, an aryloxyamino group, a carbamoylamino group, a sulfamoylamino group, a halogen atom, a sulfamoylcarbamoyl group, a carbamoylsulfamoyl group, a di-aliphatic oxyphosphinyl group, a diaryloxyphosphinyl group, an ionic hydrophilic group (e.g., carboxyl group, sulfo group, phosphono group and quaternary ammonium group), etc. These groups may be further substituted; and further substituents may be those selected from the substituents mentioned above.

In case where the azo pigment in the invention has an ionic hydrophilic group as the substituent, it is preferably a salt with a polyvalent metal cation (e.g., magnesium, calcium, barium), more preferably a lake pigment.

The Hammett substituent constant σp value used in this description will be described briefly.

The Hammett's rule is an empirical rule advocated by L. P. Hammett in 1935 for quantitatively discussing the effect of substituents on the reaction or equilibrium of benzene derivatives and the appropriateness thereof is now widely recognized. The substituent constant determined in the Hammett's rule involves σp value and σm value. These values can be found in a multiplicity of general publications, and are detailed in, for example, "Lange's Handbook of Chemistry" 12th Edition by J. A. Dean, 1979 (McGraw-Hill); "Region of Chemistry", Extra Edition, No. 122, pp. 96 to 103, 1979 (Nankodo Publishing). In the invention, the substituents may be defined or described by the Hammett substituent constant σp thereof; however, needless-to-say, this does not mean that the substituents are limited to only those whose Hammett substituent constant σp values can be found as known values in the aforementioned publications, but means that even those whose Hammett substituent constant σp values are unknown from literature but could fall within the specified ranges when measured based on the Hammett's rule are within the scope of the substituents. Although the pigments of formulae (1) or (2) in the invention are not benzene derivatives, the σp value is used as the criterion showing the electronic effect of the substituent irrespective of the substituent position. Accordingly, in the invention, the σp value is used in this meaning.

### <Azo Pigment>

Pigment is in a state where colorant molecules firmly bond to each other by cohesion energy through strong interaction between the molecules. To form this state, intermolecular van der Waals force and intermolecular hydrogen bonding are necessary, and this is described, for example, in the Journal of the Imaging Society of Japan, Vol. 43, p. 10 (2004).

For increasing the intermolecular van der Waals force, introducing an aromatic group, a polar group and/or a hetero atom into molecules may be taken into consideration. For forming the intermolecular hydrogen bonding, introducing a substituent having a hydrogen atom bonding to a hetero atom into molecules and/or introducing an electron-donating substituent thereinto may be taken into consideration. Further, it may be considered that the polarity of the molecule as a whole is preferably higher. For this, for example, it may be considered that the linear group such as the alkyl group is preferably shorter, and the molecular weight and the size of the azo group are preferably smaller.

From these viewpoints, the pigment molecules preferably have an amide bond, a sulfonamide bond, an ether bond, a sulfone group, an oxycarbonyl group, an imide group, a carbamoylamino group, a hetero ring, a benzene ring or the like.

The azo pigment for use in the invention is represented by the following formula (1).

The compound of formula (1) may readily form an intermolecular interaction of colorant molecules owing to the specific structure thereof, and is poorly soluble in water or organic solvent, and therefore can be an azo pigment.

Dye is used by dissolving it in water or in an organic solvent as dispersed therein as molecules; however, different from such dye, pigment is used as finely dispersed as solid particles of molecule aggregates in a solvent.

As having a specific structure represented by the following formula (1), the azo pigment exhibits excellent color characteristics of coloring power and hue, and is excellent in durability such as lightfastness and ozone resistance.

The pigment of formula (1) is described below. 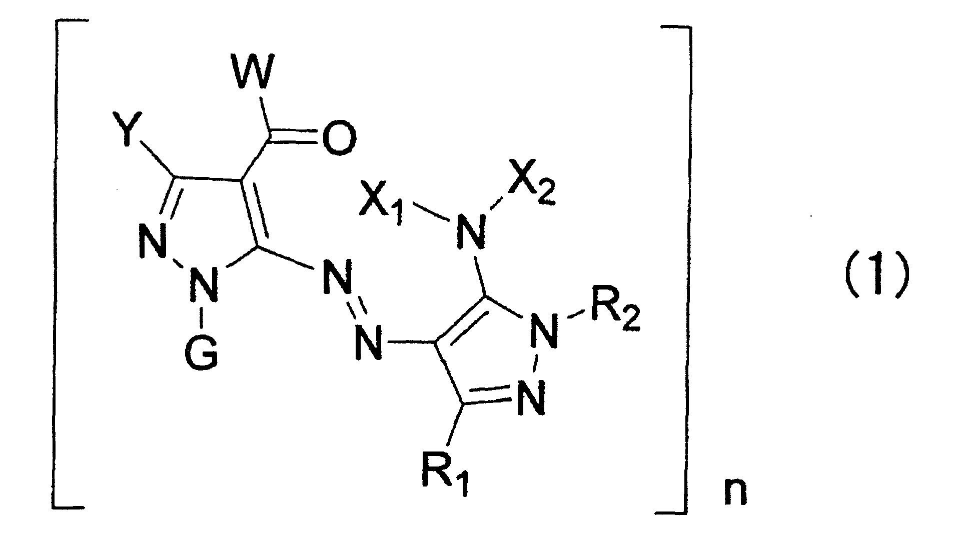 In formula (1), Y represents a hydrogen atom or a substituent; W represents an alkoxy group, an amino group, an alkyl group or an aryl group; G represents a hydrogen atom, an alkyl group, a cycloalkyl group, an aralkyl group, an alkenyl group, an alkynyl group, an aryl group or a heterocyclic group; X₁ and X₂ each independently represent a hydrogen atom, an alkyl group, an acyl group, an alkylsulfonyl group or an arylsulfonyl group; R₁ represents a hydrogen atom or a substituent; R₂ represents a heterocyclic group; n indicates an integer of from 1 to 4; when n = 2, the formula represents a dimer via G, W, X₁, X₂, R₁ or R₂; when n = 3, the formula represents a trimer via G, W, X₁, X₂, R₁ or R₂; when n = 4, the formula represents a tetramer via G, W, X₁, X₂, R₁ or R₂.

When n is 1, G, W, X₁, X₂, R₁ and R₂ each are a monovalent group, and the compound is a mono-type azo pigment represented by the parenthesized structure.

When n is 2, G, W, X₁, X₂, R₁ and R₂ each are a monovalent or divalent group, but at least one of them is a divalent group. The compound is a bis-type azo pigment of the parenthesized colorant.

When n is 3, G, W, X₁, X₂, R₁ and R₂ each are a monovalent, divalent or trivalent group, but at least two of them are a divalent group or at least one of them is a trivalent group. The compound is a tris-type azo pigment of the parenthesized colorant.

When n is 4, G, W, X₁, X₂, R₁ and R₂ each are a monovalent, divalent, trivalent or tetravalent group, but at least two of them are a divalent group, or at least one of them is a trivalent group, or at least one of them is a tetravalent group. The compound is a tetra-type azo pigment of the parenthesized colorant.

Preferably, n is an integer of from 1 to 3, more preferably 1 or 2, most preferably 2. When n is 2, then it is favorable since the solubility of the pigment in water or organic solvent is low (or that is, the pigment is substantially hardly soluble therein) and since the water resistance and the chemical resistance of the pigment is good.

In formula (1), X₁ and X₂ each are independently a hydrogen atom, an alkyl group, an acyl group, an alkylsulfonyl group or an arylsulfonyl group.

The alkyl group for X₁ and X₂ may be independently linear, branched or cyclic, substituted or unsubstituted alkyl group, including a cycloalkyl group, a bicycloalkyl group, and even a tricyclic structure having a larger number of ring structures. The same concept shall apply to the alkyl group in the substituent to be mentioned below (for example, the alkyl group of alkoxy group or alkylthio group).

Precisely, the alkyl group is preferably an alkyl group having from 1 to 30 carbon atoms, including, for example, a methyl group, an ethyl group, an n-propyl group, an isopropyl group, a t-butyl group, an n-octyl group, an eicosyl group, a 2-chloroethyl group, a 2-cyanoethyl group, a 2-ethylhexyl group, etc. The cycloalkyl group is preferably a substituted or unsubstituted cycloalkyl group having from 3 to 30 carbon atoms, including, for example, a cyclohexyl group, a cyclopentyl group, a 4-n-dodecylcyclohexyl group, etc. The bicycloalkyl group is preferably a substituted or unsubstituted bicycloalkyl group having from 5 to 30 carbon atoms, or that is, a monovalent group derived from a bicycloalkane having from 5 to 30 carbon atoms by removing one hydrogen atom from it, including, for example, a bicyclo[1,2,2]heptan-2-yl group, a bicyclo[2,2,2]octan-3-yl group, etc.

Preferably, the acyl group for X₁ and X₂ is independently a formyl group, a substituted or unsubstituted alkylcarbonyl group having from 2 to 30 carbon atoms, a substituted or unsubstituted arylcarbonyl group having from 7 to 30 carbon atoms, or a substituted or unsubstituted heterocyclic carbonyl group bonding to the carbonyl group via a carbon atom and having from 2 to 30 carbon atoms, including, for example, an acetyl group, a pivaloyl group, a 2-chloroacetyl group, a stearoyl group, a benzoyl group, a p-n-octyloxyphenylcarbonyl group, a 2-pyridylcarbonyl group, a 2-furylcarbonyl group, etc.

Preferably, the alkylsulfonyl group or arylsulfonyl group for X₁ and X₂ is independently a substituted or unsubstituted alkylsulfonyl group having from 1 to 30 carbon atoms, or a substituted or unsubstituted arylsulfonyl group having from 6 to 30 carbon atoms, including, for example, a methylsulfonyl group, an ethylsulfonyl group, a phenylsulfonyl group, a p-methylphenylsulfonyl group, etc.

Of those, preferably, X₁ and X₂ each are independently a hydrogen atom, an acyl group, or an alkylsulfonyl group, more preferably a hydrogen atom. Most preferably, X₁ and X₂ are both hydrogen atoms.

In case where at least one of X₁ and X₂ is a hydrogen atom, the compound can form an intramolecular crossover hydrogen bond composed of the oxygen atom of the carbonyl group, the nitrogen atom of the azo group and the hydrogen atom of X₁ or X₂, therefore favorably bettering the color and the image fastness with the pigment.

In formula (1), W represents an alkoxy group, an amino group, an alkyl group or an aryl group.

The alkoxy group for W is preferably a substituted or unsubstituted alkoxy group having from 1 to 30 carbon atoms, including, for example, a methoxy group, an ethoxy group; an isopropoxy group, a t-butoxy group, an n-octyloxy group, a 2-methoxyethoxy group, etc.

The amino group for W includes an alkylamino group, an arylamino group, and a heterocyclic amino group, and is preferably an amino group, a substituted or unsubstituted alkylamino group having from 1 to 30 carbon atoms, or a substituted or unsubstituted anilino group having from 6 to 30 carbon atoms, including, for example, a methylamino group, a dimethylamino group, an anilino group, an N-methylanilino group, a diphenylamino group, etc.

The alkyl group for W may be a linear, branched or cyclic, substituted or unsubstituted alkyl group, and includes a cycloalkyl group, a bicycloalkyl group, and even a tricyclic structure having a larger number of ring structures. The same concept shall apply to the alkyl group in the substituent to be mentioned below (for example, the alkyl group of alkoxy group or alkylthio group). Precisely, the alkyl group is preferably an alkyl group having from 1 to 30 carbon atoms, including, for example, a methyl group, an ethyl group, an n-propyl group, an isopropyl group, a t-butyl group, an n-octyl group, an eicosyl group, a 2-chloroethyl group, a 2-cyanoethyl group, a 2-ethylhexyl group, etc. The cycloalkyl group is preferably a substituted or unsubstituted cycloalkyl group having from 3 to 30 carbon atoms, including, for example, a cyclohexyl group, a cyclopentyl group, a 4-n-dodecylcyclohexyl group, etc. The bicycloalkyl group is preferably a substituted or unsubstituted bicycloalkyl group having from 5 to 30 carbon atoms, or that is, a monovalent group derived from a bicycloalkane having from 5 to 30 carbon atoms by removing one hydrogen atom from it, including, for example, a bicyclo[1,2,2]heptan-2-yl group, a bicyclo[2,2,2]octan-3-yl group, etc.

The aryl group for W is preferably a substituted or unsubstituted aryl group having from 6 to 30 carbon atoms, including, for example, a phenyl group, a p-tolyl group, a naphthyl group, an m-chlorophenyl group, an o-hexadecanoylaminophenyl group, etc.

Of those, preferably, W is an alkoxy group, an amino group or an alkyl group, more preferably an alkoxy group or an amino group, even more preferably an alkoxy group having a total carbon number of at most 5, an amino group (-NH₂ group), or an alkylamino group having a total carbon number of at most 5, still more preferably an amino group (-NH₂ group), an alkoxy group having a total carbon number of at most 3 (e.g., methoxy group, ethoxy group), or an alkylamino group having a total carbon number of at most 3 (e.g., -NHCH₃ group, -N(CH₃)₂ group); and above all, most preferably a methoxy group (-OCH₃ group). In case where W is an alkoxy group having a total carbon number of at most 5, an amino group, or an alkylamino group having a total carbon number of at most 5, the colorant molecules can readily form a strong intramolecular and intermolecular interaction and therefore can constitute a pigment of more stable molecular configuration. Accordingly, the case is preferred from the viewpoint of good coloration and fastness (lightfastness, vapor resistance, heat resistance, water resistance, chemical resistance) of the pigment. More preferred is a methoxy group, an ethoxy group or an amino group from the viewpoint of the good coloration, lightfastness and solvent resistance of the pigment. Above all, a methoxy group is most preferred from the viewpoint of the good coloration and lightfastness of the pigment.

In formula (1), R₁ is a hydrogen atom or a substituent. In case where R₁ is a substituent, the substituent includes a linear or branched alkyl group having from 1 to 12 carbon atoms, a linear or branched aralkyl group having from 7 to 18 carbon atoms, a linear or branched alkenyl group having from 2 to 12 carbon atoms, a linear or branched alkynyl group having from 2 to 12 carbon atoms, a cycloalkyl group having from 3 to 12 carbon atoms, a cycloalkenyl group having from 3 to 12 carbon atoms (e.g., methyl, ethyl, n-propyl, i-propyl, n-butyl, i-butyl, sec-butyl, t-butyl, 2-ethylhexyl, 2-methylsulfonylethyl, 3-phenoxypropyl, trifluoromethyl, cyclopentyl), a halogen atom (e.g., chlorine atom, bromine atom), an aryl group (e.g., phenyl, 4-t-butylphenyl, 2,4-di-t-amylphenyl), a heterocyclic group (e.g., imidazolyl, pyrazolyl, triazolyl, 2-furyl, 2-thienyl, 2-pyrimidinyl, 2-benzothiazolyl), a cyano group, a hydroxyl group, a nitro group, a carboxy group, an amino group, an alkyloxy group (e.g., methoxy, ethoxy, 2-methoxyethoxy, 2-methylsulfonylethoxy), an aryloxy group (e.g., phenoxy, 2-methylphenoxy, 4-b-butylphenoxy, 3-nitrophenoxy, 3-t-butyloxycarbonylphenoxy, 3-methoxycarbonylphenyloxy), an acylamino group (e.g., acetamide, benzamide, 4-(3-t-butyl-4-hydroxyphenoxy)butanamide), an alkylamino group (e.g., methylamino, butylamino, diethylamino, methylbutylamino), an arylamino group (e.g., phenylamino, 2-chloroanilino), an ureido group (e.g., phenylureido, methylureido, N,N-dibutylureido), a sulfamoylamino group (e.g., N,N-dipropylsulfamoylamino), an alkylthio group (e.g., methylthio, octylthio, 2-phenoxyethylthio), an arylthio group (e.g., phenylthio, 2-butoxy-5-t-octylphenylthio, 2-carboxyphenylthio), an alkyloxycarbonylamino group (e.g., methoxycarbonylamino), an alkylsulfonylamino group and an arylsulfonylamino group (e.g., methylsulfonylamino, phenylsulfonylamino, p-toluenesulfonylamino), a carbamoyl group (e.g., N-ethylcarbamoyl, N,N-dibutylcarbamoyl), a sulfamoyl group (e.g., N-ethylsulfamoyl, N,N-dipropylsulfamoyl, N-phenylsulfamoyl), a sulfonyl group (e.g., methylsulfonyl, octylsulfonyl, phenylsulfonyl, p-toluenesulfonyl), an alkyloxycarbonyl group (e.g., methoxycarbonyl, butyloxycarbonyl), a heterocyclic oxy group (e.g., 1-phenyltetrazol-5-oxy, 2-tetrahydropyranyloxy), an azo group (e.g., phenylazo, 4-methoxyphenylazo, 4-pivaloylaminophenylazo, 2-hydroxy-4-propanoylphenylazo), an acyloxy group (e.g., acetoxy), a carbamoyloxy group (e.g., N-methylcarbamoyloxy, N-phenylcarbamoyloxy), a silyloxy group (e.g., trimethylsilyloxy, dibutylmethylsilyloxy), an aryloxycarbonylamino group (e.g., phenoxycarbonylamino), an imido group (e.g., N-succinimide, N-phthalimide), a heterocyclic thio group (e.g., 2-benzothiazolylthio, 2,4-di-phenoxy-1,3,5-triazole-6-thio, 2-pyridylthio), a sulfinyl group (e.g., 3-phenoxypropylsulfinyl), a phosphonyl group (e.g., phenoxyphosphonyl, octyloxyphosphonyl, phenylphosphonyl), an aryloxycarbonyl group (e.g., phenoxycarbonyl), an acyl group (e.g., acetyl, 3-phenylpropanoyl, benzoyl), an ionic hydrophilic group (e.g., carboxyl group, sulfo group, phosphono group, quaternary ammonium group).

In formula (1), R₁ is preferably a substituted or unsubstituted acylamino group having a total carbon number of from 1 to 8, a substituted or unsubstituted alkyl group having a total carbon number of from 1 to 12, a substituted or unsubstituted aryl group having a total carbon number of from 6 to 18, or a substituted or unsubstituted heterocyclic group having a total carbon number of from 4 to 12, more preferably a linear alkyl group or branched alkyl group having a total carbon number of from 1 to 8, even more preferably a methyl group, an i-propyl group or a t-butyl group, still more preferably an i-propyl group or a t-butyl group; and above all, most preferably a t-butyl group.

When R₁ and R₂ each are a linear alkyl group or branched alkyl group having a smaller total carbon number (preferably having a total carbon number of from 1 to 8, more preferably from 1 to 4), the steric control of the colorant molecule alignment configuration is easy (the molecules can be aligned at regular intervals and at controlled angles). As a result, pigment particles having a stable intramolecular/intermolecular interaction can be readily formed, and these are favorable from the viewpoint of the color hue, the coloring power and the image fastness with the pigment.

In formula (1), R₂ represents a heterocyclic group, and it may form a condensed ring. Preferably, R₂ is a 5- to 8-membered heterocyclic group, more preferably 5- or 6-membered, substituted or unsubstituted heterocyclic group, even more preferably a 6-membered nitrogen-containing heterocyclic group having from 3 to 10 carbon atoms.

Examples of the heterocyclic group for R₂ are, as expressed with no limitation on the substituent position, pyridyl, pyrazinyl, pyridazinyl, pyrimidinyl, triazinyl, quinolinyl, isoquinolinyl, quinazolinyl, cinnolinyl, phthalazinyl, quinoxalinyl, pyrrolyl, indolyl, furyl, benzofuryl, thienyl, benzothienyl, pyrazolyl, imidazolyl, benzimidazolyl, triazolyl, oxazolyl, benzoxazolyl, thiazolyl, benzothiazolyl, isothiazolyl, benzisothiazolyl, thiadiazolyl, isoxazolyl, benzisoxazolyl, pyrrolidinyl, piperidinyl, piperazinyl, imidazolidinyl, thiazolinyl, sulfolanyl, etc.

Preferred examples of the hetero ring include a pyridine ring, a pyrimidine ring, an S-triazine ring, a pyridazine ring, pyrazine ring, a 1,2,4-thiadiazole ring, a 1,3,4-thiadiazole ring, an imidazole ring; more preferred are a pyridine ring, a pyrimidine ring, an S-triazine ring, a pyridazine ring, a pyrazine ring; even more preferred are a pyrimidine ring and an S-triazine ring from the viewpoint of the color hue, the coloring power and the image fastness with the pigment. Still more preferred are a pyrimidine ring having a substituent that contains the azo group corresponding to formula (1) at 4,6-positions, and an S-triazine ring having an alkoxy group with from 1 to 4 carbon atoms at the 2-position, from the viewpoint of the color hue and the image fastness; and above all, most preferred is a pyrimidine ring having a substituent that contains the azo group corresponding to formula (1) at 4,6-positions, from the viewpoint of the color hue and the lightfastness of the pigment.

In case where R₂ is a 6-membered nitrogen-containing hetero ring, the pigment is preferred from the viewpoint of enhancing the intramolecular/intermolecular interaction of the colorant molecules, the hydrogen bonding behavior and the planarization of the molecules.

Examples of G include a hydrogen atom, an alkyl group, a cycloalkyl group, an aralkyl group, an alkenyl group, an alkynyl group, an aryl group and a heterocyclic group, preferably a hydrogen atom, a methyl group, an ethyl group, an n-propyl group, an isopropyl group a t-butyl group, a cyclopropyl group, a benzyl group, a 2-phenethyl group, a vinyl group, an allyl group, an ethynyl group, a propargyl group, a phenyl group, a p-tolyl group, a naphthyl group, a pyridyl group, a pyrimidinyl group and a pyrazinyl group, more preferably a hydrogen atom, a methyl group, a phenyl group, a pyridyl group, a pyrimidinyl group and a pyrazinyl group; and of those, especially preferred are a linear alkyl group or a branched alkyl group having a total carbon number of from 1 to 8, a 2-pyridyl group, a 2,6-pyrimidinyl group, and a 2,5-pyrazinyl group; and even more preferred is an alkyl group having a total carbon number of at most 3 from the viewpoint of the color hue and the image fastness; and most preferred is a methyl group from the viewpoint of the color hue and the bettered lightfastness of the pigment.

Examples of the substituent for Y include a halogen tom, an alkyl group, an aralkyl group, an alkenyl group, an alkynyl group, an aryl group, a heterocyclic group, a cyano group, a hydroxyl group, a nitro group, an alkoxy group, an aryloxy group, a silyloxy group, a heterocyclic oxy group, an acyloxy group, a carbamoyloxy group, an alkoxycarbonyloxy group, an aryloxycarbonyloxy group, an amino group, an acylamino group, an aminocarbonylamino group, an alkoxycarbonylamino group, an aryloxycarbonylamino group, a sulfamoylamino group, an alkyl or arylsulfonylamino group, a mercapto group, an alkylthio group, an arylthio group, a heterocyclic thio group, a sulfamoyl group, an alkyl or arylsulfinyl group, an alkyl or arylsulfonyl group, an acyl group, an aryloxycarbonyl group, an alkoxycarbonyl group, a carbamoyl group, an aryl or heterocyclic azo group, an imide group, a phosphino group, a phosphinyl group, a phosphinyloxy group, a phosphinylamino group, a silyl group. Preferred examples of Y are a hydrogen atom, an alkyl group (e.g., methyl group), an aryl group (e.g., phenyl group), a heterocyclic group (e.g., 2-pyridyl group), an alkylthio group (e.g., methylthio group); more preferably a hydrogen atom, a linear or branched alkyl group having a total carbon number of from 1 to 4, a phenyl group, and a methylthio group, even more preferably a hydrogen atom, and a methyl group from the viewpoint of the color hue and the image fastness. Above all, most preferred is a hydrogen atom from the viewpoint of the bettered color hue and the enhanced lightfastness of the pigment.

Regarding the preferred combination of the substituents in the pigment of formula (1) for use in the invention, preferred are the compounds where at least one of various substituents therein is the above-mentioned preferred group; and more preferred are the compounds where a larger number of substituents therein are the above-mentioned preferred groups; and most preferred are the compounds where all the substituents therein are the above-mentioned preferred groups.

Especially preferred combinations for the azo pigment of formula (1) for use in the invention include the following (a) to (g):
(a) X₁ and X₂ are preferably, each independently a hydrogen atom, an alkyl group (e.g., methyl group, ethyl group, n-propyl group, isopropyl group, t-butyl group, cyclopropyl group), an acyl group (e.g., formyl group, acetyl group, pivaloyl group, benzoyl group), an alkylsulfonyl group (e.g., methylsulfonyl group, ethylsulfonyl group), or an arylsulfonyl group (e.g., phenylsulfonyl group), more preferably a hydrogen atom, an acetyl group, or a methylsulfonyl group, even more preferably a hydrogen atom. Above all, especially preferably at least one of X₁ and X₂ is a hydrogen atom, and most preferably these are both hydrogen atoms. In case where at least one of X₁ and X₂ is a hydrogen atom, not only the intermolecular interaction of colorant molecules but also the intramolecular interaction thereof can be formed firmly, and the pigments of the type can have a stable molecular configuration and are preferred from the viewpoint of good color hue and high fastness (to light, vapor, heat, water, chemicals) thereof.
(b) W is preferably an alkoxy group (e.g., methoxy group, ethoxy group, isopropoxy group, t-butoxy group), an amino group (e.g., -NH₂ group, methylamino group, dimethylamino group, anilino group), an alkyl group (e.g., methyl group, ethyl group, n-propyl group, isopropyl group, t-butyl group, cyclopropyl group), or an aryl group (e.g., phenyl group, p-tolyl group, naphthyl group). Above all, especially preferred is an alkoxy group, an amino group or an alkyl group; more preferred is an alkoxy group or an amino group; even more preferred is an alkoxy group having a total carbon number of at most 5, an amino group (-NH₂ group), or an alkylamino group having a total carbon number of at most 5; still more preferred is an alkoxy group having a total carbon number of at most 3, an amino group (-NH₂ group), or an alkylamino group having a total carbon number of at most 3; and most preferred among them is a methoxy group (-OCH₃ group).
(c) R₁ is preferably a hydrogen atom, or a substituent (e.g., substituted or unsubstituted acylamino group having a total carbon number of from 1 to 8, substituted or unsubstituted alkyl group having a total carbon number of from 1 to 12, substituted or unsubstituted aryl group having a total carbon number of from 6 to 18, substituted or unsubstituted heterocyclic group having a total carbon number of from 4 to 12), more preferably a linear alkyl group or branched alkyl group having a total carbon number of from 1 to 8, even more preferably a methyl group, an i-propyl group or a t-butyl group, still more preferably an i-propyl group or a t-butyl group; and most preferred among them is a t-butyl group.
(d) R₂ is a heterocyclic group, and it may form a condensed ring. Preferably, R₂ is a 5- to 8-membered heterocyclic group, more preferably a 5- or 6-membered, substituted or unsubstituted heterocyclic group, even more preferably a 6-membered nitrogen-containing heterocyclic group having from 3 to 10 carbon atoms. More preferred examples of the hetero ring are a pyridine ring, a pyrimidine ring, an S-triazine ring, a pyridazine ring, a pyrazine ring, a 1,2,4-thiadiazole ring, a 1,3,4-thiadiazole ring, an imidazole ring; more preferred are a pyridine ring, a pyrimidine ring, an S-triazine ring, a pyridazine ring, a pyrazine ring; even more preferred are a pyrimidine ring and an S-triazine ring; still more preferred are a pyrimidine ring having a substituent at the 4,6-positions, and an S-triazine ring having an alkoxy group with from 1 to 4 carbon atoms at the 2-position. Above all, most preferred is a pyrimidine ring having a substituent at the 4,6-positions.
(e) G is a hydrogen atom, an alkyl group, a cycloalkyl group, an aralkyl group, an alkenyl group, an alkynyl group, an aryl group or a heterocyclic group, preferably a hydrogen atom, a methyl group, an ethyl group, an n-propyl group, an isopropyl group, a t-butyl group, a cyclopropyl group, a benzyl group, a 2-phenethyl group, a vinyl group, an allyl group, an ethynyl group, a propargyl group, a phenyl group, a p-tolyl group, a naphthyl group, a pyridyl group, a pyrimidinyl group, or a pyrazinyl group, more preferably a hydrogen atom, a methyl group, a phenyl group, a pyridyl group, a pyrimidinyl group, or a pyrazinyl group; and among them, more preferred is a methyl group, a 2-pyridyl group, a 2,6-pyrimidinyl group, or a 2,5-pyrazinyl group, even more preferred is an alkyl group having a total carbon number or at most 3, and most preferred is a methyl group.
(f) Y is a hydrogen atom, an alkyl group (e.g., methyl group), an aryl group (e.g., phenyl group), a heterocyclic group (e.g., 2-pyridyl group), or an alkylthio group (e.g., methylthio group), preferably a hydrogen atom, a methyl group, a phenyl group or a methylthio group, and among them, most preferably a hydrogen atom.
(g) n is preferably an integer of from 1 to 3, more preferably 1 or 2, most preferably n = 2.

In the color composition for color filter of the invention, the azo pigment of formula (1) is preferably an azo pigment of the following formula (2): 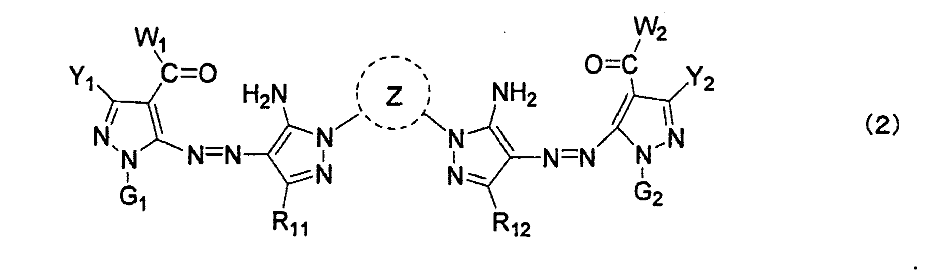 In formula (2), Z represents a 5- to 8-membered nitrogen-containing hetero ring; Y₁, Y₂, R₁₁ and R₁₂ each independently represent a hydrogen atom or a substituent; G₁ and G₂ each independently represent a hydrogen atom, a cycloalkyl group, an alkyl group, an aralkyl group, an alkenyl group, an alkynyl group, an aryl group or a heterocyclic group; W₁ and W₂ each independently represent an alkoxy group, an amino group, an alkyl group or an aryl group.

In formula (2), Y₁ and Y₂ have the same meanings as those of Y in formula (1), and preferred examples thereof are also the same as those of Y

In formula (2), R₁₁ and R₁₂ have the same meanings as those of R₁ in formulas (1), and preferred examples thereof are also the same as those of R₁.

In formula (2), G₁ and G₂ have the same meanings as those of G in formula (1), and preferred examples thereof are also the same as those of G

In formula (2), W₁ and W₂ have the same meanings as those of W in formula (1), and preferred examples thereof are also the same as those of W.

In formula (2), Z represents a 5- to 8-membered nitrogen-containing hetero ring, and this may form a condensed ring. Z is preferably a 5- or 6-membered, substituted or unsubstituted nitrogen-containing heterocyclic group, more preferably a 6-membered nitrogen-containing heterocyclic group having from 3 to 10 carbon atoms.

Examples of the heterocyclic group are, as expressed with no limitation on the substituent position, pyridyl, pyrazinyl, pyridazinyl, pyrimidinyl, triazinyl, quinolinyl, isoquinolinyl, quinazolinyl, cinnolinyl, phthalazinyl, quinoxalinyl, pyrrolyl, indolyl, pyrazolyl, imidazolyl, benzimidazolyl, triazolyl, oxazolyl, benzoxazolyl, thiazolyl, benzothiazolyl, isothiazolyl, benzisothiazolyl, thiadiazolyl, isoxazolyl, benzisoxazolyl, pyrrolidinyl, piperidinyl, piperazinyl, imidazolidinyl, thiazolinyl, etc.

Preferred examples of the hetero ring include a pyridine ring, a pyrimidine ring, an S-triazine ring, a pyridazine ring, pyrazine ring, a 1,2,4-thiadiazole ring, a 1,3,4-thiadiazole ring, an imidazole ring; more preferred are a pyridine ring, a pyrimidine ring, an S-triazine ring, a pyridazine ring, a pyrazine ring; even more preferred are a pyrimidine ring and an S-triazine ring from the viewpoint of the color hue, the coloring power and the image fastness with the pigment. Still more preferred are a pyrimidine ring having a substituent that contains the azo group corresponding to formula (2) at 4,6-positions, and an S-triazine ring having an alkoxy group with from 1 to 4 carbon atoms at the 2-position, from the viewpoint of the color hue and the image fastness; and above all, most preferred is a pyrimidine ring having a substituent that contains the azo group corresponding to formula (2) at 4,6-positions, from the viewpoint of the color hue and the lightfastness of the pigment.

In case where Z is a 6-membered nitrogen-containing hetero ring, the pigment is preferred from the viewpoint of enhancing the intramolecular/intermolecular interaction of the colorant molecules, the hydrogen bonding behavior and the planarization of the molecules.

Regarding the preferred combination of the substituents in the pigment of formula (2) for use in the invention, preferred are the compounds where at least one of various substituents therein is the above-mentioned preferred group; and more preferred are the compounds where a larger number of substituents therein are the above-mentioned preferred groups; and most preferred are the compounds where all the substituents therein are the above-mentioned preferred groups.

Especially preferred combinations for the azo pigment of formula (2) for use in the invention include the following (a) to (e):
(a) Z is preferably a pyrrole ring, a pyrazole ring, a triazole ring, an imidazole ring, a thiazole ring, an isothiazole ring, an oxazole ring, an isoxazole ring, a thiadiazole ring, a pyridine ring, a pyrimidine ring, a triazine ring, or a pyridazine ring. More preferably, it is a 6-membered nitrogen-containing hetero ring, for example, a pyridine ring, a pyrimidine ring, or an S-triazine ring. Z is preferably an S-triazine ring, more preferably an S-triazine ring having an alkoxy group with from 1 to 4 carbon atoms at the 2-position, even more preferably an S-triazine ring having a methoxy group at the 2-position.
(b) W₁ and W₂ are preferably, each independently an alkoxy group (e.g., methoxy group, ethoxy group, isopropoxy group, t-butoxy group), an amino group (e.g., -NH₂ group, methylamino group, dimethylamino group, anilino group), an alkyl group (e.g., methyl group, ethyl group, n-propyl group, isopropyl group, t-butyl group, cyclopropyl group), or an aryl group (e.g., phenyl group, p-tolyl group, naphthyl group). Above all, especially preferred is an alkoxy group, an amino group or an alkyl group; more preferred is an alkoxy group or an amino group; even more preferred is an alkoxy group having a total carbon number of at most 5, an amino group (-NH₂ group), or an alkylamino group having a total carbon number of at most 5; still more preferred is an alkoxy group having a total carbon number of at most 3 (e.g., methoxy group, ethoxy group) or an alkylamino group having a total carbon number of at most 3 (e.g., -NHCH₃ group, -N(CH₃)₂ group); and among them, most preferred is a methoxy group (-OCH₃ group).
(c) R₁₁ and R₁₂ are preferably, each independently a hydrogen atom, or a substituent (e.g., substituted or unsubstituted acylamino group having a total carbon number of from 1 to 8, substituted or unsubstituted alkyl group having a total carbon number of from 1 to 12, substituted or unsubstituted aryl group having a total carbon number of from 6 to 18, substituted or unsubstituted heterocyclic group having a total carbon number of from 4 to 12), more preferably a linear alkyl group or branched alkyl group having a total carbon number of from 1 to 8, even more preferably a methyl group, an i-propyl group or a t-butyl group, still more preferably an i-propyl group or a t-butyl group; and most preferred among them is a t-butyl group.
(d) G₁ and G₂ are each independently a hydrogen atom, an alkyl group, a cycloalkyl group, an aralkyl group, an alkenyl group, an alkynyl group, an aryl group or a heterocyclic group, preferably a hydrogen atom, a methyl group, an ethyl group, an n-propyl group, an isopropyl group, a t-butyl group, a cyclopropyl group, a benzyl group, a 2-phenethyl group, a vinyl group, an allyl group, an ethynyl group, a propargyl group, a phenyl group, a p-tolyl group, a naphthyl group, a pyridyl group, a pyrimidinyl group, or a pyrazinyl group, more preferably a hydrogen atom, a methyl group, a phenyl group, a pyridyl group, a pyrimidinyl group, or a pyrazinyl group; and among them, especially preferred is a linear alkyl group or branched alkyl group having a total carbon number of from 1 to 8, a 2-pyridyl group, a 2,6-pyrimidinyl group, or a 2,5-pyrazinyl group, and even more preferred is an alkyl group having a total carbon number of at most 3; and among them, most preferred is a methyl group.
(e) Y₁ and Y₂ each are a hydrogen atom, an alkyl group (e.g., methyl group), an aryl group (e.g., phenyl group), a heterocyclic group (e.g., 2-pyridyl group), or an alkylthio group (e.g., methylthio group), preferably a hydrogen atom, a linear or branched alkyl group having a total carbon number of from 1 to 4, a phenyl group or a methylthio group, more preferably a hydrogen atom or a methyl group; and among them, most preferred is a hydrogen atom.

In the invention, the azo pigment of formula (1) or formula (2) is more preferably an azo pigment of the following formula (3):

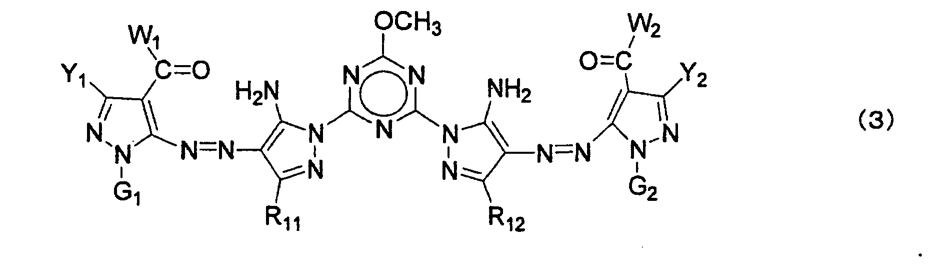

In formula (3), Y₁, Y₂, R₁₁ and R₁₂ each independently represent a hydrogen atom or a substituent; G1 and G2 each independently represent a hydrogen atom, an alkyl group, a cycloalkyl group, an aralkyl group, an alkenyl group, an alkynyl group, an aryl group or a heterocyclic group; W₁ and W₂ each independently represent an alkoxy group, an amino group, an alkyl group or an aryl group.

In formula (3), Y₁ and Y₂ have the same meanings as those of Y₁ and Y₂ in formula (2), and preferred examples thereof are also the same as those of Y₁ and Y₂.

In formula (3), R₁₁ and R₁₂ have the same meanings as those of R₁₁ and R₁₂ in formula (2), and preferred examples thereof are also the same as those of R₁₁ and R₁₂.

In formula (3), G₁ and G₂ have the same meanings as those of G₁ and G₂ in formula (2), and preferred examples thereof are also the same as those of G₁ and G₂.

In formula (3), W₁ and W₂ have the same meanings as those of W₁ and W₂ in formula (2), and preferred examples thereof are also the same as those of W₁ and W₂.

Regarding the preferred combination of the substituents in the pigment of formula (3) for use in the invention, preferred are the compounds where at least one of various substituents therein is the above-mentioned preferred group; and more preferred are the compounds where a larger number of substituents therein are the above-mentioned preferred groups; and most preferred are the compounds where all the substituents therein are the above-mentioned preferred groups.

Especially preferred combinations for the azo pigment of formula (3) for use in the invention include the following (a) to (d):
(a) W₁ and W₂ are preferably, each independently an alkoxy group (e.g., methoxy group, ethoxy group, isopropoxy group, t-butoxy group), an amino group (e.g., -NH₂ group, methylamino group, dimethylamino group, anilino group), an alkyl group (e.g., methyl group, ethyl group, n-propyl group, isopropyl group, t-butyl group, cyclopropyl group), or an aryl group (e.g., phenyl group, p-tolyl group, naphthyl group). Above all, especially preferred is an alkoxy group, an amino group or an alkyl group; more preferred is an alkoxy group or an amino group; even more preferred is an alkoxy group having a total carbon number of at most 5, an amino group (-NH₂ group), or an alkylamino group having a total carbon number of at most 5; still more preferred is an alkoxy group having a total carbon number of at most 3 (e.g., methoxy group, ethoxy group) or an alkylamino group having a total carbon number of at most 3 (e.g., -NHCH₃ group, -N(CH₃)₂ group); and among them, most preferred is a methoxy group (-OCH₃ group).
(b) R₁₁ and R₁₂ are preferably, each independently a hydrogen atom, or a substituent (e.g., substituted or unsubstituted acylamino group having a total carbon number of from 1 to 8, substituted or unsubstituted alkyl group having a total carbon number of from 1 to 12, substituted or unsubstituted aryl group having a total carbon number of from 6 to 18, substituted or unsubstituted heterocyclic group having a total carbon number of from 4 to 12), more preferably a linear alkyl group or branched alkyl group having a total carbon number of from 1 to 8, even more preferably a methyl group, an i-propyl group or a t-butyl group, still more preferably an i-propyl group or a t-butyl group; and most preferred among them is a t-butyl group.
(c) G₁ and G₂ are each independently a hydrogen atom, an alkyl group, a cycloalkyl group, an aralkyl group, an alkenyl group, an alkynyl group, an aryl group or a heterocyclic group, preferably a hydrogen atom, a methyl group, an ethyl group, an n-propyl group, an isopropyl group, a t-butyl group, a cyclopropyl group, a benzyl group, a 2-phenethyl group, a vinyl group, an allyl group, an ethynyl group, a propargyl group, a phenyl group, a p-tolyl group, a naphthyl group, a pyridyl group, a pyrimidinyl group, or a pyrazinyl group, more preferably a hydrogen atom, a methyl group, a phenyl group, a pyridyl group, a pyrimidinyl group, or a pyrazinyl group; and among them, especially preferred is a linear alkyl group or branched alkyl group having a total carbon number of from 1 to 8, a 2-pyridyl group, a 2,6-pyrimidinyl group, or a 2,5-pyrazinyl group, and even more preferred is an alkyl group having a total carbon number of at most 3; and among them, most preferred is a methyl group.
(d) Y₁ and Y₂ each are a hydrogen atom, an alkyl group (e.g., methyl group), an aryl group (e.g., phenyl group), a heterocyclic group (e.g., 2-pyridyl group), or an alkylthio group (e.g., methylthio group), preferably a hydrogen atom, a linear or branched alkyl group having a total carbon number of from 1 to 4, a phenyl group or a methylthio group, more preferably a hydrogen atom or a methyl group; and among them, most preferred is a hydrogen atom.

In the invention, the azo pigment of formula (1), formula (2) of formula (3) is more preferably an azo pigment having a crystalline morphology of the following formula (4):

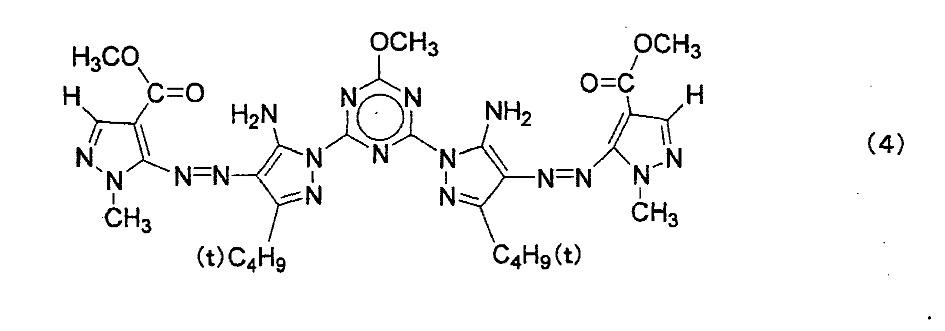

Preferably, the colorant including the azo pigment of formula (4) or a tautomer thereof shows characteristic X-ray diffraction peaks at Bragg angles (2θ ± 0.2°) of 7.2° and 25.9° in CuKα characteristic X-ray diffractometry.

Containing the azo pigment of formula (4), the color composition for color filter can satisfy both good color hue and high image fastness.

Accordingly, the azo pigment of formula (4) and its tautomer preferably have a crystalline morphology having a characteristic X-ray diffraction peaks at Bragg angles (2θ ± 0.2°) of 7.2° and 25.9° in CuKα characteristic X-ray diffractometry, more preferably a crystalline morphology having characteristic X-ray diffraction peaks at 7.2°, 15.0°, 19.8° and 25.9°, and above all, most preferably a crystalline morphology having characteristic X-ray diffraction peaks at 7.2°, 8.2°, 10.0°, 13,4°, 15.0°, 19.8° and 25.9°.

In the invention, the azo pigment having a crystalline morphology of the above-mentioned formulae (1) to (3) and formula (4) may be analyzed for X-ray diffractiometry according to the Japanese Industrial Standards JIS K0131 (general rule of X-ray diffractiometry), using a powdery X-ray diffractiometer RINT 2500 (by Rigaku).

When observed with a transmission microscope, the length in the long axis direction of the primary particles of the azo pigment of the above-mentioned formulae (1) to (3) and formula (4) is preferably from 0.01 µm to 30 µm, more preferably from 0.02 µm to 10 µm, most preferably from 0.03 µm to 1 µm.

The azo pigment whose primary particles, as observed with a transmission microscope, have a length in the long axis direction of at least 0.01 µm can more surely exhibit good fastness to light and ozone and, when formed into a pigment dispersion, the pigment secures better dispersibility. On the other hand, the azo pigment whose primary particles have a length of at most 30 µm are advantageous in that, when the pigment particles are dispersed to have a desired volume-average particle diameter, they are hardly in an over-dispersed state (in a state where the primary particles are broken), and the active surface of the pigment particles is hardly exposed out, and therefore the particles hardly aggregate, and for these reasons, the pigment dispersion can secure more the storage stability thereof.

The azo pigment whose primary particles have a length in the long axis direction falling within the above range is preferred since its fastness to light and ozone is high and since the pigment dispersion is excellent in storage stability.

Specific examples of the azo pigment of formula (1) are shown below; however, the azo compounds of the azo pigments for use in the invention should not be limited to the following examples. The structures of the following examples are shown as limited structural formulae of some types of possible tautomers which the azo compound may have in point of the chemical structure thereof; however, needless-to-say, the azo pigment may have any other tautomeric structure than the structure shown below.

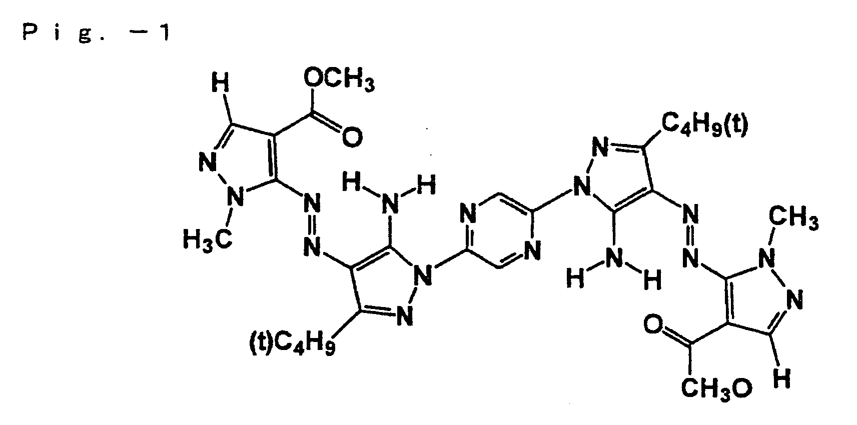

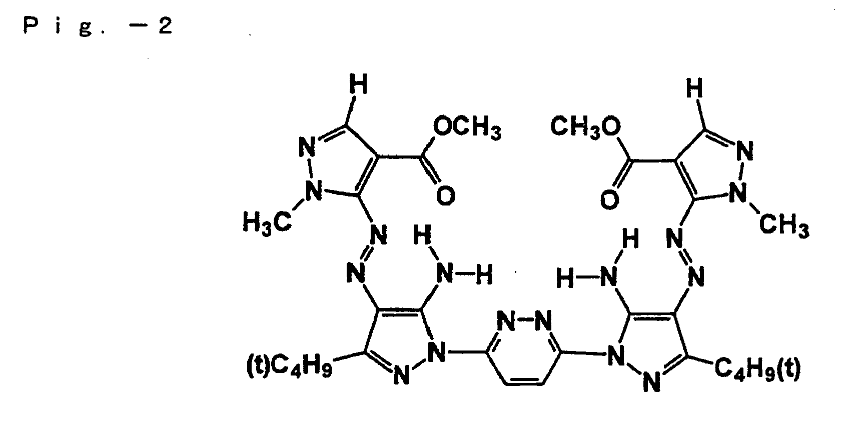

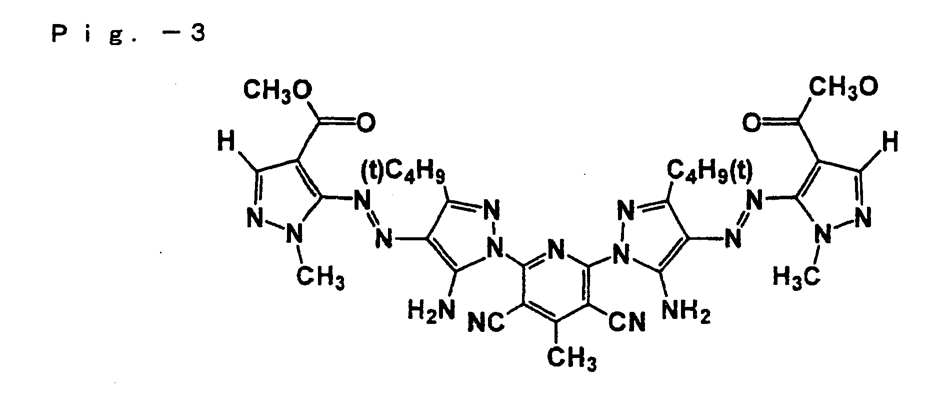

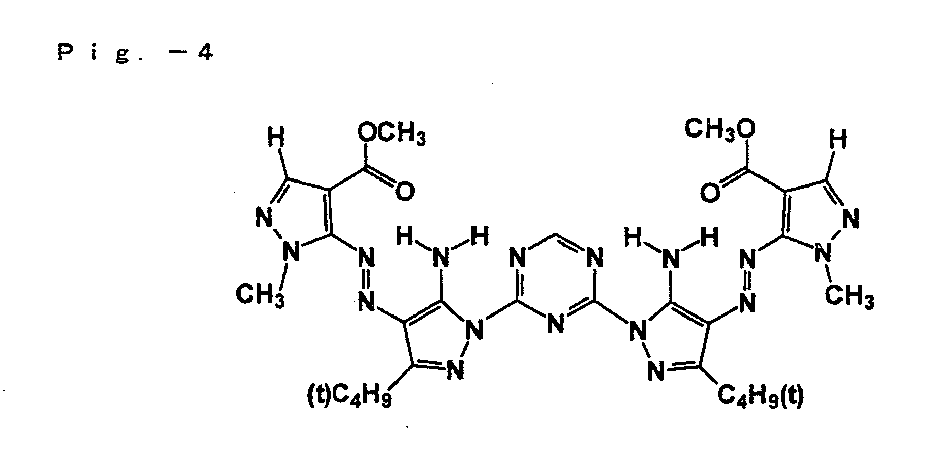

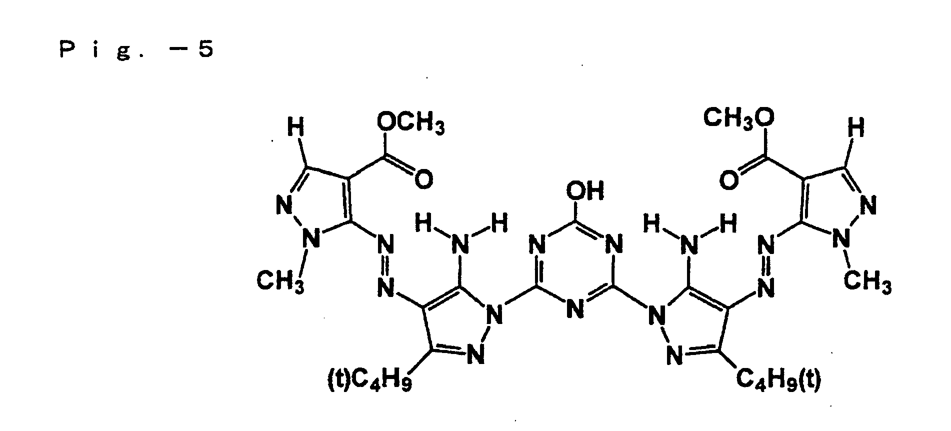

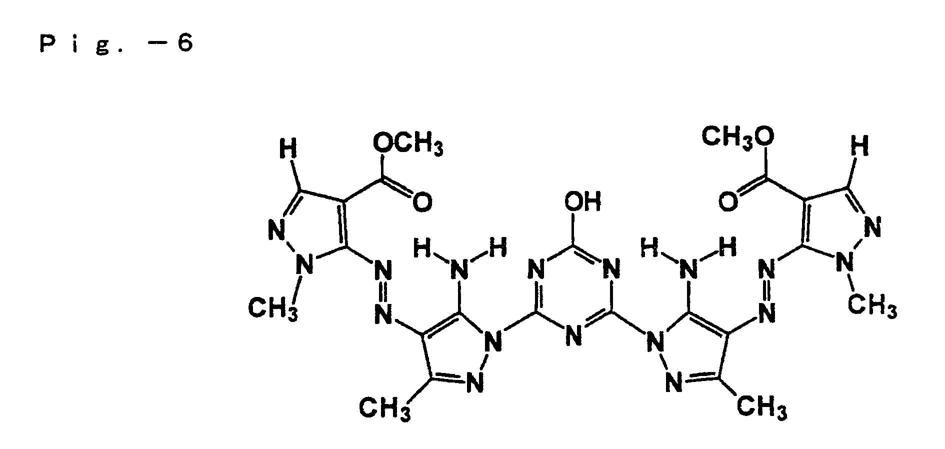

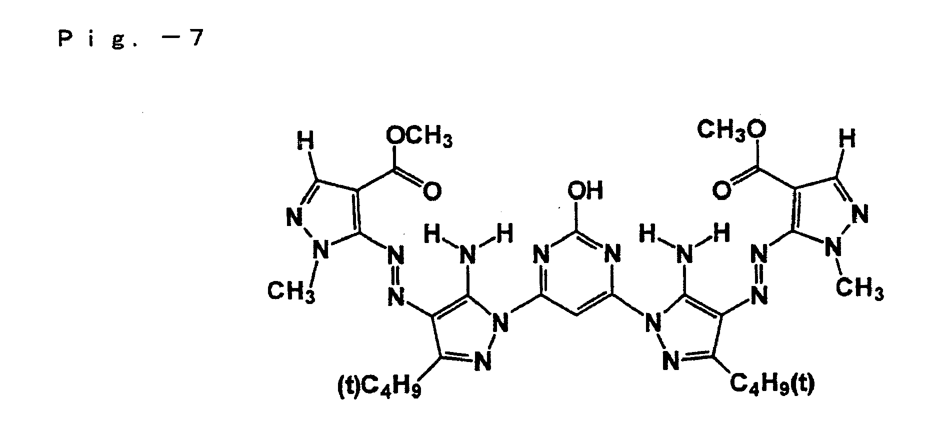

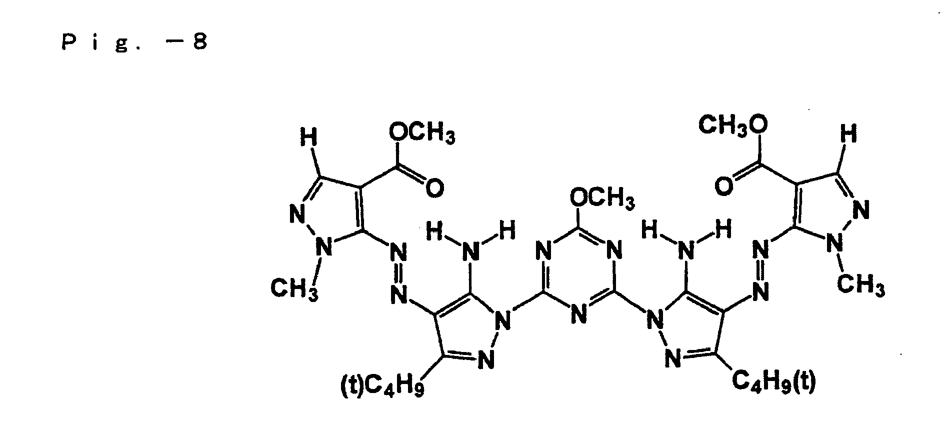

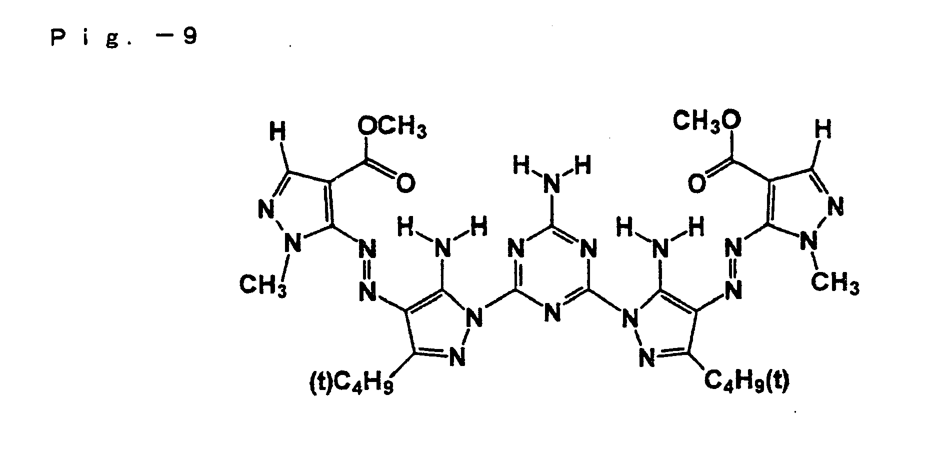

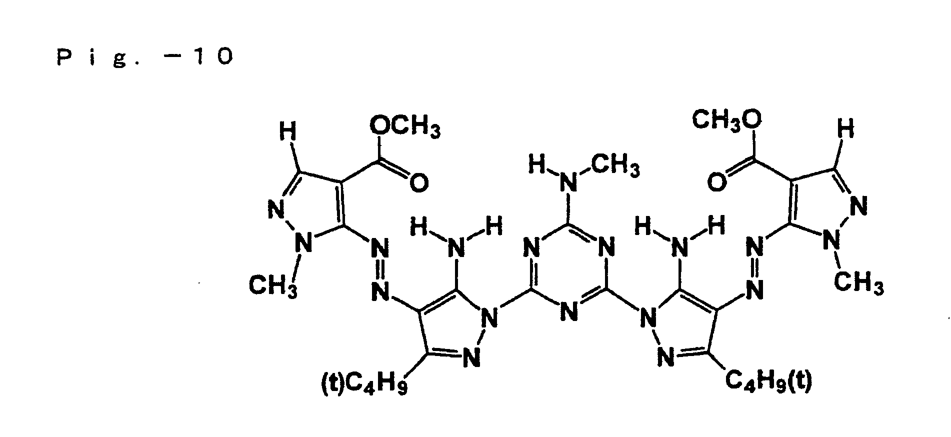

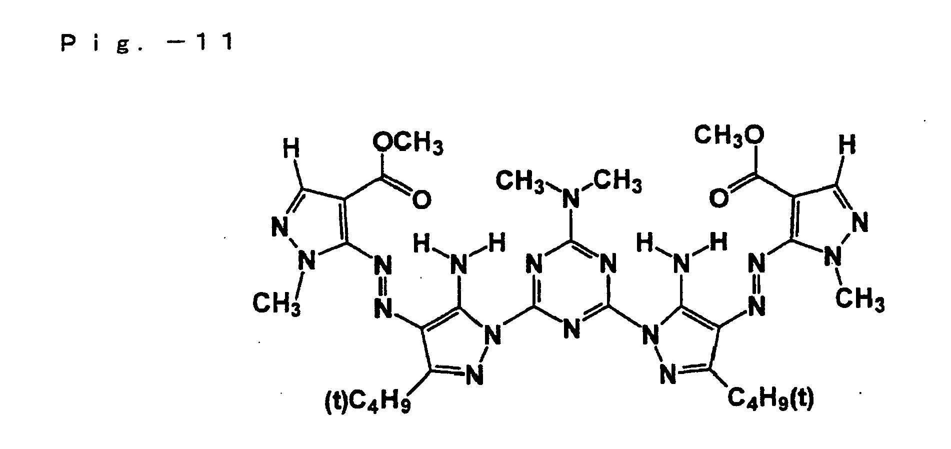

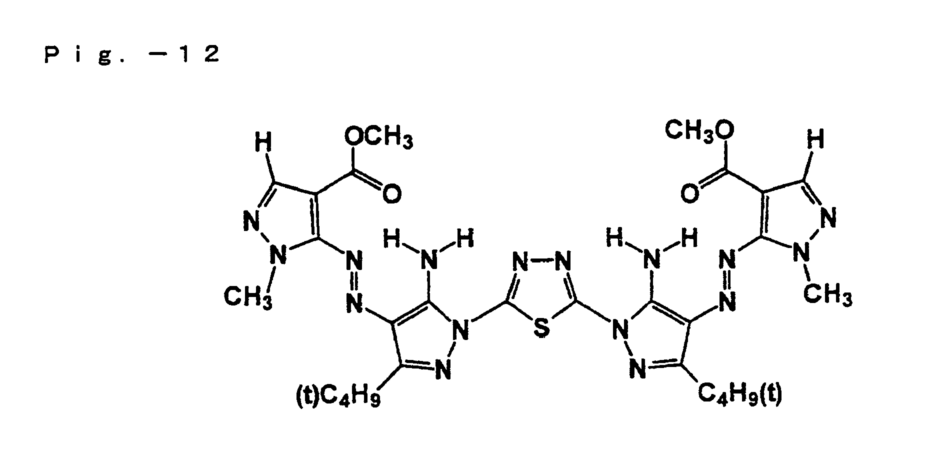

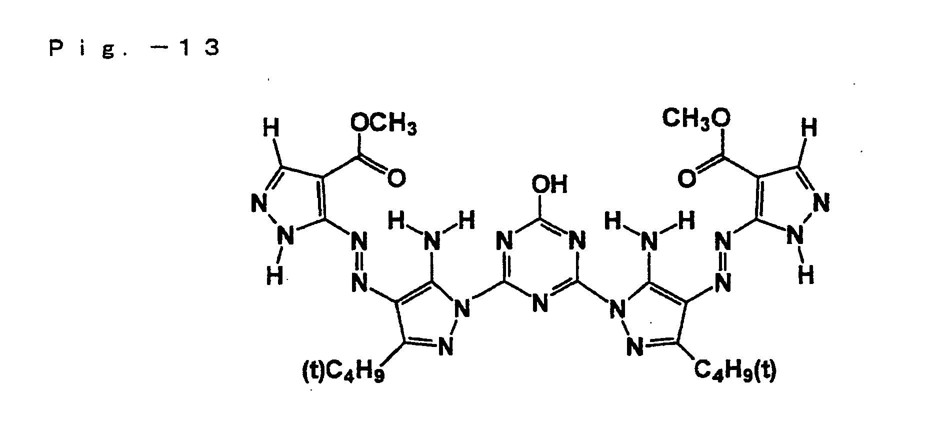

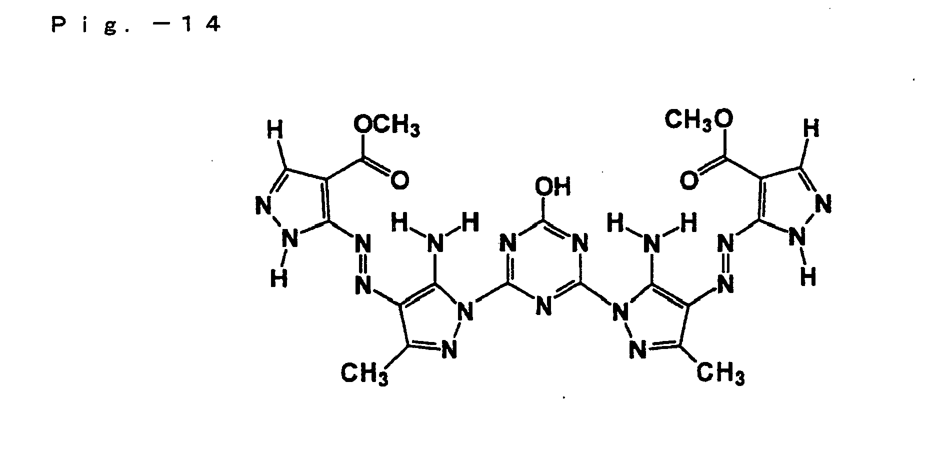

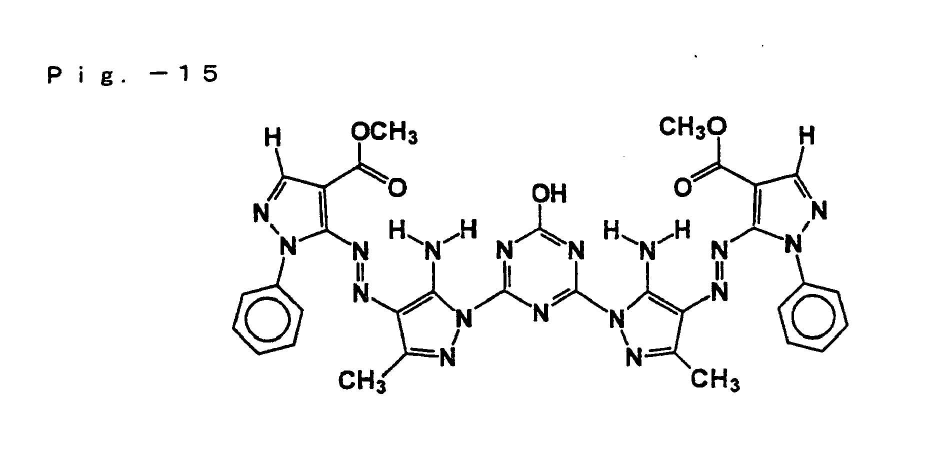

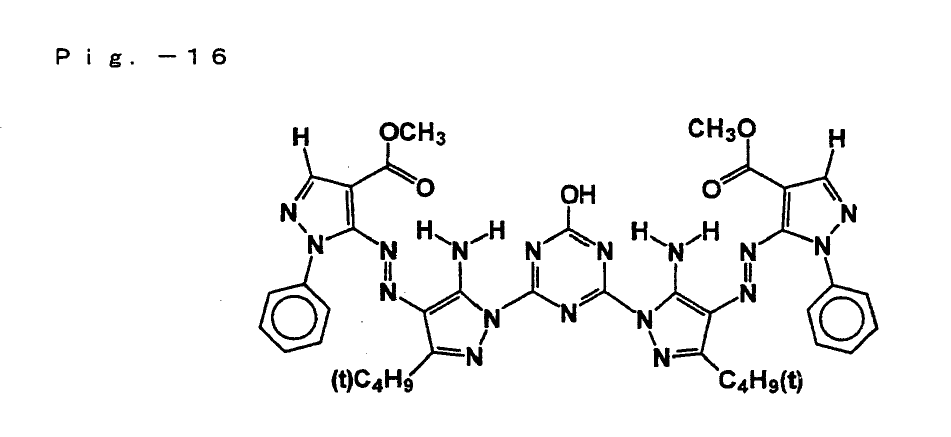

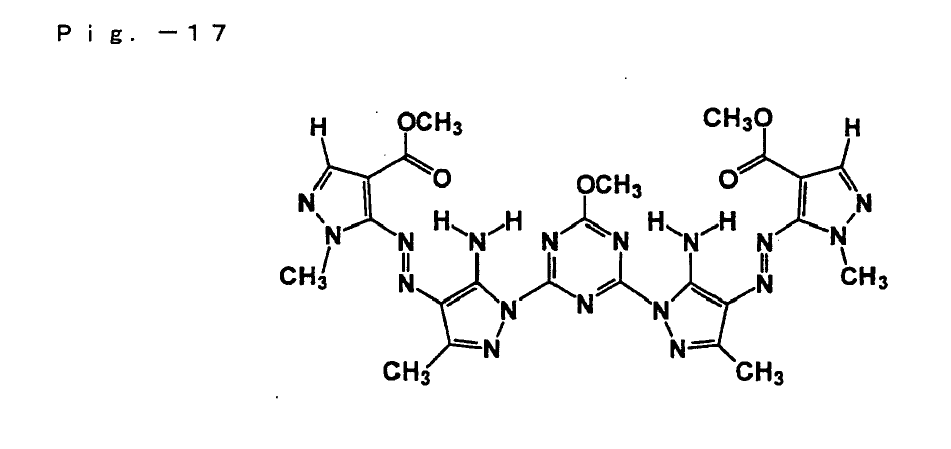

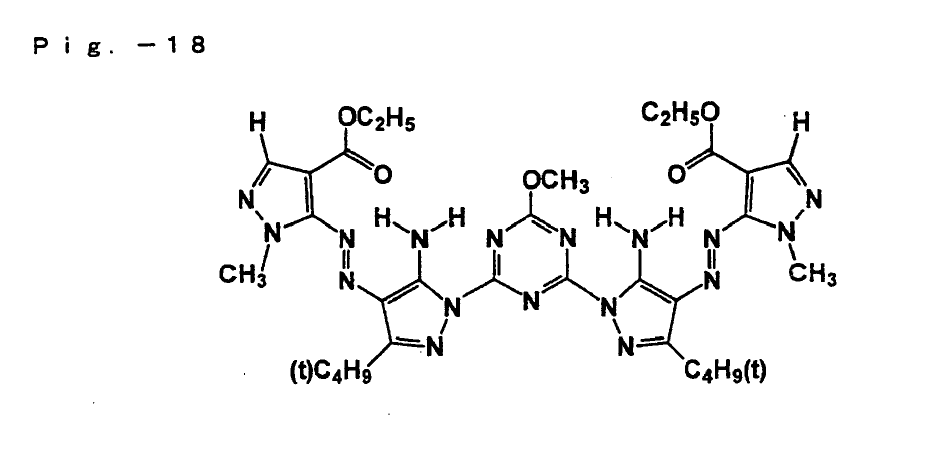

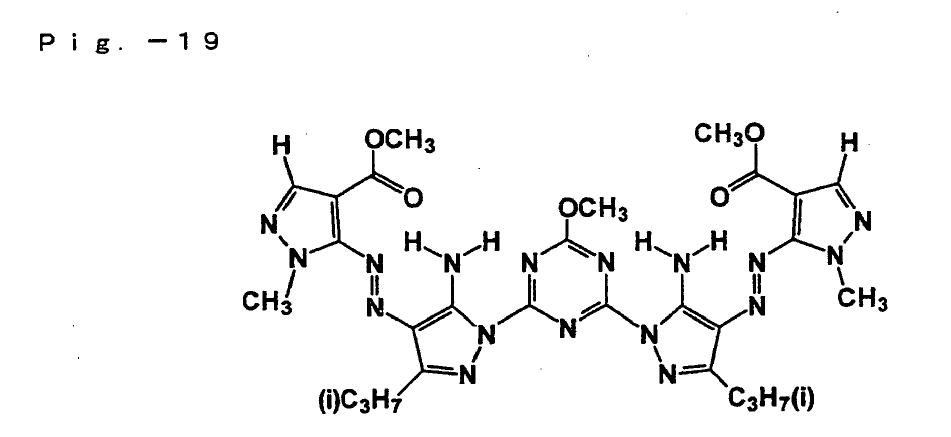

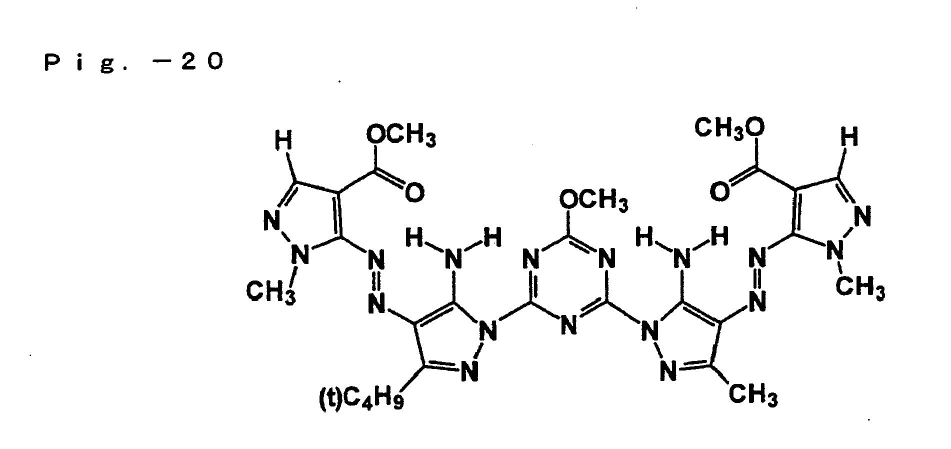

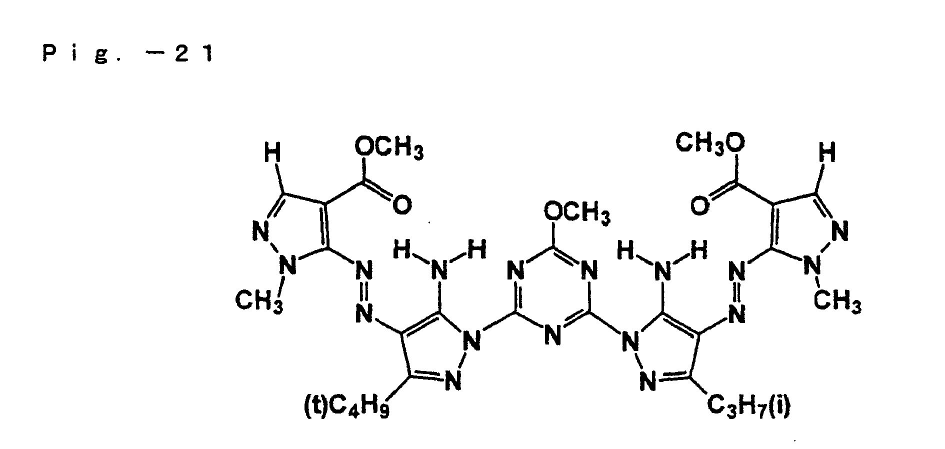

The azo pigment of formula (1) gives a large number of tautomers.

In the invention, preferably, the azo pigment of formula (1) has a substituent that forms an intramolecular hydrogen bond or an intramolecular crossover hydrogen bond. More preferably, the azo pigment has at least one substituent forming an intramolecular crossover hydrogen bond, even more preferably at least three substituents each forming an intramolecular hydrogen bond, and still more preferably, at least two of these hydrogen bonds of the substituents form an intramolecular crossover hydrogen bond.

The pigment of formula (1) in the invention may be a pigment having a chemical structure represented by formula (1) or any tautomer of formula (1) thereof, and may be a pigment having any crystalline morphology referred to as polymorphism.

Crystalline polymorphism is meant to indicate crystals each having the same chemical composition but differing from each other in point of the configuration of the building blocks (molecules or ions) in the individual crystals. The chemical and physical properties of the crystals are determined according to the crystal structure thereof; and each polymorphism can be differentiated from another in point of the rheology, the color and other color characteristics thereof. In addition, different polymorphisms can be identified through X-ray diffractiometry (powdery X-ray diffractiometric patterns) as well as X-ray analysis (X-ray crystal structure analysis data).

In case where the pigment of formulae (1) to (3) for use in the invention has a crystalline polymorphism, the pigment of any polymorphism is usable here, and a mixture of two or more different types of polymorphisms is also usable. Preferably, however, the pigment comprises mainly a monomorphic crystalline pigment. In other words, preferably, the pigment does not contain a crystalline polymorphic pigment. The content of the azo pigment having a crystalline monomorphism is preferably from 70% to 100% of the entire azo pigment, more preferably from 80% to 100%, even more preferably from 90% to 100%, still more preferably 100%. The substantially monomorphic crystalline azo pigment is advantageous in that the regularity of the colorant molecule alignment therein is bettered and the intermolecular/intramolecular interaction of the pigment is enhanced, and therefore, the pigment can readily form a higher order three-dimensional network structure. As a result, the azo pigment of the type is preferred in point of the necessary properties of good color hue, and enhanced fastness to light, heat, moisture, oxidizing gas, solvent, etc.

The ratio of the crystalline polymorphism in the azo pigment may be confirmed from the solid physicochemical data of the dye to be determined through single-crystal X-ray crystallographic analysis, powdery X-ray diffractiometry (XRD), crystal photomicroscopy (TEM), IR (KBr method), etc.

The acid group, if any, in the azo pigment of formula (1) for use in the invention may be partly or entirely in the form of a salt thereof, and the azo pigment may be in the form of mixture of a salt-type pigment and a free acid-type pigment thereof. Examples of the salt include alkali metal salts with Na, Li, K or the like, ammonium salts optionally substituted with an alkyl group or a hydroxyalkyl group, and salts with an organic amine. Examples of the organic amine include a lower alkylamine, a hydroxy-substituted lower alkylamine, a carboxy-substituted lower alkylamine, a polyamine having from 2 to 10 alkylenimine units with from 2 to 4 carbon atoms each, etc. The type of the salts is not limited to one. The azo pigment may be in the form of a mixture of two or more different types of such salts as combined.

Regarding the structure of the pigment for use in the invention, plural acid groups, if any, in one molecule of the pigment may be in the form of a salt thereof or a free acid, and the plural acid groups may differ in the structure.

The azo pigment of formula (1) for use in the invention may be in the form of a hydrate containing water molecules in the crystal thereof.

One example of a production method for the azo pigment of formula (1) is described below. For example, a heterocyclic amine of the following formula (A) is diazonized under an acidic condition, then coupled with a compound of the following formula (B) and thereafter post-treated in an ordinary manner to produce an azo pigment of formula (1).

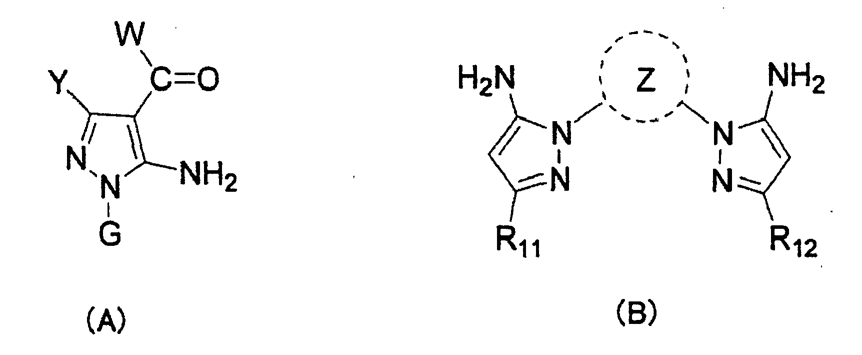

In formulae (A) and (B), W, Y, G, R₁₁, R₁₂ and Z have the same meanings as those of W₁, Y₁, G₁, R₁₁, R₁₂ and Z in formula (2).

The heterocyclic amine of formula (A) can be produced, in general, according to a known conventional method, for example, according to the method described in Helv. Chim. Acta, 41, 1958, 1052-1056, or Helv. Chim. Acta, 42, 1959, 349-352, or according to a method similar thereto.

The compound of formula (B) can be produced according to the method described in WO06/082669 and JP-A 2006-57076, or according to a method similar thereto.

### [Step of Preparing Diazonium Salt of Heterocyclic Amine]

Preparation of a diazonium salt of the heterocyclic amine (diazo component) of formula (A), and coupling of the diazonium salt with the compound of formula (B) (coupling component) may be attained in conventional methods.

To preparation of a diazonium salt of the heterocyclic amine of formula (A), a conventional diazonium salt preparation method is applicable, which comprises using a nitrosonium ion source, for example, nitrous acid, nitrite or nitrosyl sulfuric acid in a reaction medium containing an acid (e.g., hydrochloric acid, sulfuric acid, phosphoric acid, acetic acid, propionic acid, methanesulfonic acid, trifluoromethanesulfonic acid).

Preferred examples of the acid include acetic acid, propionic acid, methanesulfonic acid, phosphoric acid and sulfuric acid, and these may be used either singly or as combined. Of those, more preferred are phosphoric acid; a combination of acetic acid and sulfuric acid; a combination of acetic acid and propionic acid; a combination of acetic acid, propionic acid and sulfuric acid; and even more preferred are a combination of acetic acid and propionic acid, and a combination of acetic acid, propionic acid and sulfuric acid.

As preferred examples of the reaction medium (solvent), an organic acid and an inorganic acid are preferably used. More preferred are phosphoric acid, sulfuric acid, acetic acid, propionic acid and methanesulfonic acid; and among them, even more preferred are acetic acid and/or propionic acid.

Preferred examples of the nitrosonium ion include nitrites esters, nitrite salts, nitrosyl sulfuric acid, etc. Of those, more preferred are sodium nitrite, potassium nitrite, isoamyl nitrite, nitrosyl sulfuric acid (e.g., ONHSO₄ sulfuric acid solution); and even more preferred are isoamyl nitrite, nitrosyl sulfuric acid (e.g., 40 mas.% to 50 mas.% ONHSO₄ sulfuric acid solution). Above all, especially preferred is use of nitrosyl sulfuric acid in the above-mentioned preferred acid-containing reaction solvent, as capable of stably and efficiently preparing a diazonium salt.

The amount of the solvent to be used relative to the diazo component of formula (A) is preferably from 0.5 to 50 times by mass, more preferably from 1 to 20 times by mass, even more preferably from 3 to 15 times by mass.

In the invention, the diazo component of formula (A) may be in a state dispersed in a solvent, or depending on the type of the diazo component, may be in a solution state.

The amount of the nitrosonium ion source to be used relative to the diazo component is preferably from 0.95 to 5.0 equivalents, more preferably from 1.00 to 3.00 equivalents, even more preferably from 1.00 to 1.10 equivalents.

The reaction temperature is preferably from -15°C to 40°C, more preferably from -5°C to 35°C, even more preferably from -0°C to 30°C. At lower than -10°C, the reaction speed is noticeably low and the time to be taken for synthesis is extremely long, and therefore it is uneconomical; and in production at a high temperature over 40°C, the amount of the side product to be produced increases and it is unfavorable.

The reaction time is preferably from 30 minutes to 300 minutes, more preferably from 30 minutes to 200 minutes, even more preferably from 30 minutes to 150 minutes.

### [Coupling Reaction Step]

The coupling reaction step may be attained in a range of from an acidic reaction medium to a basic reaction medium; however, preferably, the azo pigment in the invention is produced in a range of from an acidic to neutral reaction medium, more preferably in an acidic reaction medium in which the diazonium salt is prevented from being decomposed and is therefore efficiently derived into an azo pigment.

As preferred examples of the reaction medium (solvent), usable are an organic acid, an inorganic acid and an organic solvent. More preferred is an organic solvent; and even more preferred is a solvent not bringing about a liquid separation phenomenon during reaction and capable of forming a uniform solution with reactants. For example, the solvent includes alcoholic organic solvents such as methanol, ethanol, propanol, isopropanol, butanol, t-butyl alcohol, amyl alcohol, etc.; ketonic organic solvents such as acetone, methyl ethyl ketone, etc.; diolic organic solvents such as ethylene glycol, diethylene glycol, triethylene glycol, propylene glycol, dipropylene glycol, 1,3-propanediol, etc.; etheric organic solvents such as ethylene glycol monomethyl ether, ethylene glycol monoethyl ether, ethylene glycol diethyl ether, etc.; tetrahydrofuran, dioxane, acetonitrile, etc. The solvents may be in the form of a mixture of two or more of them.

Preferred for use herein is an organic solvent having a polarity parameter (ET) of at least 40. More preferred is a glycolic solvent having at least two hydroxyl groups in the molecule, or an alcoholic solvent a carbon number of at most 3, or a ketonic solvent having a total carbon number of at most 5; even more preferred is an alcoholic solvent having a carbon number of at most 2 (e.g., methanol, ethylene glycol), or a ketonic solvent having a total carbon number of at most 4 (e.g., acetone, methyl ethyl ketone). A mixed solvent of these is also within the preferred range.

The amount of the solvent to be used is preferably from 1 to 100 times by mass relative to the coupling component of formula (B), more preferably from 1 to 50 times by mass, even more preferably from 2 to 30 times by mass.

In the invention, the coupling component of formula (B) may be in a state dispersed in a solvent, or depending on the type of the coupling component, may be in a solution state.

The amount of the coupling component to be used is preferably such that the diazo component is from 0.95 to 5.0 equivalents per the azo-coupling site, more preferably from 1.00 to 3.00 equivalents, even more preferably from 1.00 to 1.50 equivalents.

The reaction temperature is preferably from -30°C to 30°C, more preferably from -15°C to 10°C, even more preferably from -10°C to 5°C. At lower than -30°C, the reaction speed is noticeably low and the time to be taken for synthesis is extremely long, and therefore it is uneconomical; and in production at a high temperature over 30°C, the amount of the side product to be produced increases and it is unfavorable.

The reaction time is preferably from 30 minutes to 300 minutes, more preferably from 30 minutes to 200 minutes, even more preferably from 30 minutes to 150 minutes.

In a production method for the azo pigment composition of the invention, the product (crude azo pigment) obtained according to the above-mentioned reaction may be processed according to an ordinary post-treatment method in organic synthesis reaction, and then, after purified or not after purified, it may be used for the composition.

Specifically, the product released from the reaction system may be, not purified, or after purified through recrystallization or salt formation either singly or as combined, used in the composition.

After the reaction, the reaction solvent may be evaporated away or not, and the product may be poured into water or ice, and after it is neutralized or is not neutralized, the product may be extracted with an organic solvent/water solution, and this is not purified or is purified through recrystallization, precipitation or salt formation either singly or as combined, and the thus-treated product may be used in the composition.

The production method for the azo pigment composition of the invention is described in more detail.

The production method for the azo pigment composition of the invention is characterized in that, in the coupling reaction of the diazonium compound prepared by diazonization of a heterocyclic amine of formula (A), with a compound of formula (B), the compound of formula (B) is dissolved in an organic solvent in advance and then coupled with the diazonium compound.

The reaction of preparing a diazonium salt of a heterocyclic amine of formula (A) may be attained, for example, by reacting the amine with a reagent such as sodium nitrite or nitrosyl sulfuric acid in an acidic solvent such as sulfuric acid, phosphoric acid or acetic acid, at a temperature not higher than 15°C for 10 minutes to 6 hours or so. Preferably, the coupling reaction is attained by reacting the diazonium salt prepared according to the above-mentioned method with a compound of formula (B) at a temperature not higher than 40°C, preferably not higher than 15°C for 10 minutes to 12 hours or so.

The above-mentioned tautomerization and/or crystalline polymorphism can be controlled by controlling the production condition in the coupling reaction. For producing a pigment composition containing mainly a crystal of formula (2) having characteristic X-ray diffraction peaks at 7.2° and 25.9° or a crystal of formula (3) having characteristic X-ray diffraction peaks at 7.2° and 25.9°, as a more preferred embodiment in the invention, for example, preferably employed is the method of the invention in which a compound of formula (B) is once dissolved in an organic solvent and then coupled. The organic solvent to be used in this case is, for example, an alcoholic solvent or a ketonic solvent. Preferred examples of the alcoholic solvent include methanol, ethanol, isopropanol, ethylene glycol, diethylene glycol, etc.; and of those, more preferred is methanol. Preferred examples of the ketonic solvent include acetone, methyl ethyl ketone, cyclohexanone, etc.; and of those, more preferred is acetone.

Another embodiment of the production method for the azo pigment composition of the invention is characterized in that the coupling reaction of the diazonium compound prepared by diazonization of a heterocyclic amine of formula (A), with a compound of formula (B) is attained in the presence of a polar aprotic solvent.

According to the method of coupling reaction in the presence of a polar aprotic solvent, the pigment composition comprising mainly a crystal of formula (3) having characteristic X-ray diffraction peaks at 7.2° and 25.9° can also be efficiently produced. Examples of the polar aprotic solvent include N,N-dimethylformamide, N,N-dimethylacetamide, N-methyl-2-pyrrolidone, dimethyl sulfoxide, tetramethylurea, acetone, methyl ethyl ketone, acetonitrile, and their mixed solvents. Of those solvents, more preferred are acetone, methyl ethyl ketone, N,N-dimethylacetamide, acetonitrile. In case where the solvent is sued, the compound of formula (2) or (3) may be completely dissolved in the solvent or not.

Depending on its use, the compound obtained according to the above-mentioned production method may be processed in a purification step or not, in which a base is added thereto for pH control. In pH control, the pH is preferably from 4 to 10, more preferably from 5 to 8, even more preferably from 5.5 to 7.5.

Having a pH of at most 10, the compound is preferred from the viewpoint of the color hue thereof in that the compound is neither discolored nor faded, that the reddish tone of the compound does not increase, and that the compound can secure a color hue of constant quality. Having a pH of at least 4, the compound is preferred in that, for example, when it is used as an inkjet recording ink, it is free from a problem of nozzle corrosion.

According to the above-mentioned production method, the compounds of formulae (1) to (3) and formula (4) can be produced as a crude azo pigment (crude product).

The invention also relates to the azo pigment composition produced according to the above-mentioned production method.

### [Post-Treatment Step]

The production method of the invention preferably includes a step of post-treatment. The post-treatment step includes, for example, a pigment particle controlling step of grinding treatment or solvent heating treatment such as solvent salt milling, salt milling, dry milling, solvent milling, acid pasting or the like, and a surface treatment step with resin, surfactant, dispersant, etc.

Preferably in the invention, the compounds of formulae (1) to (3) and formula (4) are processed for solvent heating treatment and/or solvent salt milling in the post-treatment step. For example, the product is refluxed in a dewatered organic solvent to give the azo pigment having a desired crystal morphology.

The solvent for use in the solvent heating treatment includes, for example, water; aromatic hydrocarbon solvents such as toluene, xylene, etc.; halogenohydrocarbon solvents such as chlorobenzene, o-dichlorobenzene, etc.; alcoholic solvents such as isopropanol, isobutanol, etc.; polar aprotic organic solvents such as N,N-dimethylformamide, N,-dimethylacetamide, N-methyl-2-pyrrolidone, acetone, methyl ethyl ketone, acetonitrile, etc.; glacial acetic acid, pyridine, their mixtures, etc. An inorganic or organic acid or a base may be further added to these solvents.

The temperature in the solvent heating treatment varies depending on the desired primary particle size of the pigment, but is preferably from 40 to 150°C, more preferably from 60 to 100°C. The treatment time is preferably from 30 minutes to 24 hours.

The solvent salt milling treatment comprises, for example, feeding a crude azo pigment, an inorganic salt and an organic solvent that does not dissolve them, into a kneading machine, and kneading and grinding them therein. As the inorganic salt, preferred is a water-soluble inorganic salt, for example, an inorganic salt such as sodium chloride, potassium chloride, sodium sulfate, etc. More preferably, the inorganic salt has a mean particle size of from 0.5 to 50 µm. The amount of the inorganic salt to be used is preferably from 3 to 20 times by mass the crude azo pigment, more preferably from 5 to 15 times by mass. The organic solvent is preferably a water-soluble organic solvent. The solvent may be in an evaporating state owing to the temperature elevation during kneading, and therefore, from the viewpoint of the safety, a high-boiling-point solvent is preferred. The organic solvent of the type includes, for example, diethylene glycol, glycerin, ethylene glycol, propylene glycol, liquid polyethylene glycol, liquid polypropylene glycol, 2-(methoxymethoxy)ethanol, 2-butoxyethanol, 2-(isopentyloxy)ethanol, 2-(hexyloxy)ethanol, diethylene glycol monomethyl ether, diethylene glycol monoethyl ether, diethylene glycol monobutyl ether, triethylene glycol, triethylene glycol monomethyl ether, 1-methoxy-2-propanol, 1-ethoxy-2-propanol, dipropylene glycol, dipropylene glycol monomethyl ether, dipropylene glycol monomethyl ether, dipropylene glycol, and their mixtures. The amount of the water-soluble organic solvent to be used is preferably from 0.1 to 5 times by mass the crude azo pigment. The kneading temperature is preferably from 20 to 130°C, more preferably from 40 to 110°C. As the kneading machine, for example, usable are kneader, mix marler, etc.

The color composition for color filer (this may be hereinafter simply referred to as "color composition") of the invention means a color composition containing at least one azo pigment of formula (1).

Preferably, the color composition of the invention further contains a polymerizable compound and a solvent.

In producing the color composition of the invention, the azo pigment prepared in the manner as above may be incorporated therein directly as it is, or may be dispersed in a solvent and the pigment dispersion may be incorporated in the composition. The azo pigment dispersion is preferred as having excellent color characteristics, durability, dispersion stability, light fastness and weather fastness.

The amount of the azo pigment of formula (1) (when combined with any other pigment, the total amount of the pigments) to be in the color composition of the invention is preferably from 0.01 to 2 parts by mass relative to 1 part by mass of the polymerizable compound therein, more preferably from 0.1 to 1 part by mass.

### [Polymerizable Compound]

The polymerizable compound may be suitably selected in consideration of the production process for color filter. The polymerizable compound includes a photosensitive compound and/or a thermosetting compound, and a photosensitive compound is preferred in the invention.

Preferably, the photosensitive compound is selected from at least one of photo-polymerizable resin, photo-polymerizable monomer and photo-polymerizable oligomer and has an ethylenic unsaturated bond. The color composition for color filter may contain an ingredient that may be a resin when cured, and may contain an ingredient alone not being a resin in the uncured state.

The photo-polymerizable compound, the photo-polymerizable monomer and the photo-polymerizable oligomer include, for example, (meth)acrylates such as 2-hydroxyethyl (meth)acrylate, 2-hydroxypropyl (meth)acrylate, 2-ethylhexyl (meth)acrylate, ethylene glycol di(meth)acrylate, diethylene glycol di(meth)acrylate, triethylene glycol di(meth)acrylate, polyethylene glycol di(meth)acrylate, pentaerythritol di(meth)acrylate, dipentaerythritol tetra(meth)acrylate, dipentaerythritol hexa(meth)acrylate, bisphenol A-type epoxy di(meth)acrylate, bisphenol F-type epoxy di(meth)acrylate, bisphenolfluorene-type epoxy di(meth)acrylate, etc. They also include vinyl resins such as acrylic acid (co)polymer, (meth)acrylic acid (co)polymer, maleic acid (co)polymer, etc.; resins having an ethylenic double bond in the side branch of polyethylene oxide, polyvinylpyrrolidone, polyamide, polyurethane, polyether, polyester, etc. One or more of these may be used either singly or as combined. The amount of the polymerizable compound to be in the color filter composition is preferably from 20 to 95% by mass of the total solid content of the composition, more preferably from 40 to 80% by mass.

If desired, any other resin or the like may be incorporated into the composition, and in this case, preferably, the total amount of the polymerizable compound and the additional resin falls within the above range. The total solid content means the content of the solid that remains in the composition after drying and curing, not containing a solvent but containing a monomer.

### [Photopolymerization Initiator]

In case where a photosensitive compound is used as the polymerizable compound, a photopolymerization initiator is used along with the monomer and/or oligomer of the photosensitive compound. The photopolymerization initiator may be at least one selected from benzophenone derivatives, acetophenone derivatives, benzoin derivatives, benzoin ether derivatives, thioxanthone derivatives, anthraquinone derivatives, naphthoquinone derivatives, triazine derivatives, etc. The photopolymerization initiator may be combined with any other known photosensitizer for use herein.

The thermosetting resin includes, for example, melamine resin, urea resin, alkyd resin, epoxy resin, phenolic resin, cyclopentadiene resin, etc.

In this description and the claims, "photosensitive resin" and "thermosetting resin" include not only cured resins but also polymerizable monomers and/or oligomers.

Along with the above-mentioned photosensitive resin and/or thermosetting resin, any other polymerizable compound, such as acid group-having binder resin, acrylic resin, urethane resin and others that are generally used in ink, may be used herein.

### [Solvent]

The pigment dispersion may be am aqueous one or a nonaqueous one. Though varying depending on the production method for color filter, for example, a nonaqueous one is preferred for photolithography, but any one may be good in an inkjet method.

The solvent for use in the color composition of the invention includes fatty acid esters such as ethyl acetate, butyl acetate, ethylene glycol monomethyl ether acetate, propylene glycol monomethyl ether acetate, etc.; ketones such as acetone, methyl ethyl ketone, methyl isobutyl ketone, cyclohexanone, diacetone alcohol, etc.; aromatic hydrocarbons such as benzene, toluene, xylene, etc.; alcohols such as methanol, ethanol, n-propanol, isopropanol, n-butanol, etc.; glycols such as ethylene glycol, diethylene glycol, triethylene glycol, tetraethylene glycol, polyethylene glycol, propylene glycol, dipropylene glycol, tripropylene glycol, polypropylene glycol, trimethylene glycol, hexanetriol, etc.; glycerin; alkylene glycol monoalkyl ethers such as ethylene glycol monomethyl ether, ethylene glycol monoethyl ether, diethylene glycol monomethyl ether, diethylene glycol monoethyl ether, propylene glycol monomethyl ether, propylene glycol monoethyl ether, etc.; alkylene glycol dialkyl ethers such as triethylene glycol dimethyl ether, triethylene glycol diethyl ether, tetraethylene glycol dimethyl ether, tetraethylene glycol diethyl ether, etc.; ethers such as tetrahydrofuran, dioxane, diethylene glycol diethyl ether, etc.; alkanolamines such as monoethanolamine, diethanolamine, triethanolamine, etc.; nitrogen-containing polar organic solvents such as N,N-dimethylformamide, N,N-dimethylacetamide, N-methyl-2-pyrrolidone, 2-pyrrolidone, 1,3-dimethyl-2-imidazolidinone, etc.; water, etc.

Of those solvents, water-soluble ones may be used as a water-base solvent as mixed with water. Two or more of the above solvents except water may be mixed and used as an oily solvent.

As compared with the azo pigment not in the form of a dispersion thereof, the azo pigment dispersion has excellent light fastness and weather resistance.

The color composition of the invention may contain two or more azo pigments of formula (1). Not detracting from the object of the invention, at least one pigment and/or its derivative selected from other types of pigments such as azo pigment, disazo pigment, benzimidazolone pigment, condensed azo pigment, azo lake pigment, anthraquinone pigment, diketopyrrolopyrole pigment, quinacridone pigment, isoindoline pigment, isoindolinone pigment, perinone pigment, perylene pigment and the like may be in the color composition along with the azo pigment of formula (1).

The additional pigments usable in the invention are not specifically defined. Concretely, herein usable are compounds classified as pigments in the color index (C.I.; published by the Society of Dyers and Colorists), or that is, those with a color index (C.I.) number such as the following:
Yellow pigments such as C.I. Pigment Yellow 1, C.I. Pigment Yellow 3, C.I. Pigment Yellow 12, C.I. Pigment Yellow 13, C.I. Pigment Yellow 83, C.I. Pigment Yellow 138, C.I. Pigment Yellow 139, C.I. Pigment Yellow 150, C.I. Pigment Yellow 180, C.I. Pigment Yellow 185, etc.; red pigments such as C.I. Pigment Red 1, C.I. Pigment Red 2, C.I. Pigment Red 3, C.I. Pigment Red 177, C.I. Pigment Red 254, etc.; blue pigments such as C.I. Pigment Blue 15, C.I. Pigment Blue 15:3, C.I. Pigment Blue 15:4, C.I. Pigment Blue 15:6, etc.; green pigments such as C.I. Pigment Green 7, C.I. Pigment Green 36, etc.; C.I. Pigment Violet 23, C.I. Pigment Violet 23:19, etc.

The color composition may contain an inorganic pigment. Specific examples of the inorganic pigment include titanium oxide, barium sulfate, calcium carbonate, zinc flower, lead sulfate, yellow lead, zinc yellow, Bengal red (red iron(III) oxide), cadmium red, ultramarine, prussian blue, chromium oxide green, cobalt green, amber, titanium black, synthetic iron black, carbon black, etc. In the invention, one or more pigments may be in the color composition either singly or as combined.

In case where the color composition contain any other pigment than the azo pigment of formula (1), its content is preferably at most 50% by mass of the total mass of the pigment in the color composition, more preferably at most 20% by mass.

In this description, the wording "azo pigment of formula (1)" is meant to indicate not only one azo pigment of formula (1) but also a combination of two or more azo compounds of formula (1), and a combination of azo pigment of formula (1) and any other pigment.

### [Pigment Dispersion]

Preferably, the pigment dispersion is prepared by dispersing the above-mentioned azo pigment in an aqueous or nonaqueous medium, using a dispersing apparatus. As the dispersing apparatus, herein usable is any of a simple stirrer, an impeller stirring system, an in-line stirring system, a milling system (e.g., colloid mill, ball mill, sand mill, bead mill, attritor, roll mill, jet mill, paint shaker, agitator mill, etc.), an ultrasonic system, a high-pressure emulsion dispersion system (high-pressure homogenizer; concretely, commercially-available Gaulin homogenizer, microfluidizer, DeBEE 2000).

In the invention, preferably, the volume-average particle size of the pigment is from 10 nm to 250 nm. The volume-average particle size of pigment particles means the particle size of the pigment itself, or in case where an additive such as dispersant or the like adheres to the pigment, it means the particle size of the additive-adhering particle. For measuring the volume-average particle size of the pigment in the invention, used is Nanotrac UPA particle sizer (UPA-EX150, by Nikkiso). Briefly, 3 ml of a pigment dispersion is put into a sample cell, and analyzed according to a predetermined measurement method. Regarding the parameters to be inputted in the device, the ink viscosity is inputted for the viscosity, and the pigment density is for the density of the dispersed particles.

More preferably, the volume-average particle size is from 20 nm to 250 nm, even more preferably from 30 nm to 230 nm. When the volume-average particle size of the particles in the pigment dispersion is less than 20 nm, then the dispersion could not secure storage stability; but on the other hand, when more than 250 nm, then the optical density of the composition may be low.

Preferably, the concentration of the pigment to be in the pigment dispersion in the invention is within a range of from 1 to 35% by mass, more preferably from 2 to 25% by mass. Falling within the range, the dispersion is favorable since the physical values such as the surface tension and the viscosity thereof can be readily controlled.

The physical properties such as the solvent resistance, the dispersibility and the thermal transferability of the azo pigment for use in the invention may be controlled so as to be suitable for the use thereof. The azo pigment in the invention may be in any form of an emulsion dispersion or a solid dispersion in accordance with the system where it is used.

A dispersant may be incorporated in the composition for the purpose of well dispersing the components within a short period of time.

The color composition for color filter of the invention preferably contains at least one dispersant selected from surfactant, silicone additive, pigment additive, silane coupling agent and titanium coupling agent. Two or more such dispersants may be combined and added to the composition.

Specific examples of the dispersant are described below.

The surfactant may be any one having a surface-activating effect. It includes cationic, anionic, nonionic and ampholytic surfactants. Specific examples include anionic surfactants such as alkanesulfonate salts, linear alkylbenzenesulfonate salts, branched alkylbenzenesulfonate salts, alkylnaphthalenesulfonate salts, naphthalenesulfonate salt/formaldehyde condensates, alkylsulfate salts, polyoxyethylene alkyl ether sulfate salts, alkylphosphate salts, polyoxyethylene alkyl ether phosphate salts, aliphatic monocarboxylate salts, etc.; cationic surfactants such as alkylamine salts, quaternary amine salts, etc.; nonionic surfactants such as glycerin fatty acid esters, sorbitan fatty acid esters, polyoxyethylene alkyl ethers, polyoxyethylene alkylphenyl ethers, polyethylene glycol fatty acid esters, polyoxyethylene sorbitan fatty acid esters, etc.; ampholytic surfactants such as alkylbetaines, etc.; cationic, anionic, nonionic or ampholytic polymer surfactants, etc.

Specific examples of the silicone additive include polyalkylsiloxanes, polyalkylphenylsiloxanes, polyorganosiloxanes, polydimethylsiloxanes, polyorganosiloxane polyether copolymers, polyfluorosiloxanes, organosilanes, etc. Two or more such silicone additives may be combined for use herein.

The pigment additive is a pigment derivative prepared by introducing a substituent such as a basic group, an acidic group, a linear alkyl group, a branched alkyl group, a polyoxyethylene group or the like into the pigment skeleton. Preferred examples of the pigment skeleton include monoazo pigment, disazo pigment, benzimidazolone pigment, condensed azo pigment, azo lake pigment, anthraquinone pigment, diketopyrrolopyrole pigment, quinacridone pigment, isoindoline pigment, isoindolinone pigment, perinone pigment, perylene pigment, etc.

Of the pigment additives, those prepared by introducing the above-mentioned substituent into the skeleton of an azo pigment are preferred as having a good affinity for the azo compound of formula (1).

Specific examples of the silane coupling agent include vinylmethoxysilane, vinyltriethoxysilane, vinyltris(β-methoxyethoxy)silane, β-(3,4-epoxycyclohexyl)ethyltrimethoxysilane, γ-glycidoxypropyltrimethoxysilane, γ-glycidoxypropylmethyldiethoxysilane, γ-aminopropyltriethoxysilane, N-phenyl-γ-aminopropyltrimethoxysilane, γ-methacryloxypropyltrimethoxysilane, vinyltriacetoxysilane, methyltrimethoxysilane, dimethyldimethoxysilane, phenyltrimethoxysilane, diphenyldimethoxysilane, methyltriethoxysilane, dimethyldiethoxysilane, phenyltriethoxysilane, diphenyldiethoxysilane, n-butyltrimethoxysilane, isobutyltrimethoxysilane, trimethylmethoxysilane, hydroxypropyltrimethoxysilane, n-hexadecyltrimethoxysilane, n-octadecyltrimethoxysilane, etc.

Specific examples of the titanium coupling agent include isopropyl tri(N-aminoethylaminoethyl)titanate, dibutoxybistriethanolamine titanate, etc.

The amount of the dispersant to be used varies depending on the type of the dispersant to be used, but is preferably from 0.1 to 100 parts by mass relative to 100 parts by mass of the azo compound of formula (1), more preferably from 0.5 to 80 parts by mass.

The method of using the dispersant is not specifically defined, for which, for example, referred to is a known preparation method for color composition for photolithography.

The invention also relates to a method for preparing a color composition for color filter. The method for preparing a color composition for color filer of the invention comprises a step of dispersing at least one dispersant selected from surfactant, silicone additive, pigment additive, silane coupling agent and titanium coupling agent, and an azo compound of formula (1) in a part of a solvent to prepare a pigment dispersion, and a step of mixing the pigment dispersion with a polymerizable compound and a remainder of the solvent.

For the preparation method for the color composition for color filter of the invention, preferably employed is the method of the invention.

The invention also provides a color filter to be formed by the use of the above-mentioned color composition for color filter. The color filter exhibits a high contrast and good light transmittance. Concretely, at a wavelength of 650 nm, the light transmittance of the color filer is preferably at least 85%, more preferably at least 90%.

For producing the color filter of the invention, employable is any known method, and preferred are a photolithographic method and an inkjet method. The photolithographic method and the inkjet method are described in detail hereinunder.

### 1) Photolithographic Method:

In case where a color filter is produced according to a photolithographic method, a photosensitive resin is used for the polymerizable compound in the color composition for color filter of the invention. The photosensitive resin is incorporated in the color composition as a monomer and/or a oligomer thereof, along with a photopolymerization initiator; and the composition is cured through photoirradiation to form a coating film on a transparent substrate.

As the photosensitive resin, preferred is a polymer or a copolymer of a polymerizable monomer having at least one ethylenic double bound in the molecule.

As the photosensitive resin (polymerizable monomer), especially preferred are acrylates and methacrylates concretely including methyl acrylate, methyl methacrylate, butyl methacrylate, butyl acrylate, pentaerythritol tetraacrylate, pentaerythritol tetramethacrylate, pentaerythritol triacrylate, pentaerythritol trimethacrylate, dipentaerythritol hexaacrylate, dipentaerythritol hexamethacrylate, dipentaerythritol pentaacrylate, dipentaerythritol pentamethacrylate, glycerol diacrylate, glycerol dimethacrylate, 1,4-butanediol diacrylate, 1,4-butanediol dimethacrylate, bisphenol A diacrylate, bisphenol A dimethacrylate, etc.

In case where a photolithographic method is employed, a binder resin having an acidic group is added to the color composition of the invention in addition to the photosensitive resin thereto. The binder resin having an acidic group includes a resin having a carboxyl group, a hydroxyl group, a sulfonic acid group or the like, and preferred is a binder resin having a carboxyl group and/or a hydroxyl group.

As the binder resin having an acidic group, preferred is a copolymer of a monomer having an ethylenic double bond, as selected from acrylate, methacrylate, styrene, vinyl acetate, vinyl chloride, N-vinylpyrrolidone, acrylamide or the like, and a monomer having an acidic group and an ethylenic double bond, as selected from acrylic acid, methacrylic acid, p-styrenecarboxylic acid, p-styrenesulfonic acid, p-hydroxystyrene, maleic anhydride or the like.

Preferably, the binder resin having an acidic group is used in an amount of from 0.5 to 4 parts by mass relative to 1 part by mass of the photosensitive resin (polymerizable monomer), more preferably from 1 to 3 parts by mass.

The solvent for the color composition for photolithography may be at least one oily solvent selected from fatty acid esters, ketones, aromatic hydrocarbons, alcohols, glycols, glycerin, alkylene glycol monoalkyl ethers, alkylene glycol dialkyl ethers, ethers, and nitrogen-containing polar organic solvents.

The amount of the solvent to be used is preferably from 3 to 30 times by mass the total mass of the ingredients except the solvent in the color composition, more preferably from 4 to 15 times by mass.

In addition to the above-mentioned ingredients, if desired, the color composition for photolithography of the invention may contain any known additives such as wetting agent, antifading agent, emulsion stabilizer, UV absorbent, preservative, antifungal agent, pH controlling agent, surface tension controlling agent, defoaming agent, viscosity controlling agent, dispersion stabilizer, antirusting agent, chelating agent and the like (described in JP-A 2003-306623). These additives may be added to the oily phase or the aqueous phase in preparing the composition.

The color composition for color filter of the invention may be produced according to a process comprising a step of uniformly mixing and dispersing an azo compound of formula (1), a polymerizable compound, a solvent and other various additives, using an instrument such as a bead mill, a ball mill, a sand mill, a two-roll mill, a three-roll mill, a homogenizer, a kneader, a shaking disperser or the like, and a step of controlling the viscosity of the resulting dispersion using the above-mentioned solvent or the like.

For forming a color filter by the use of the color composition for color filter of the invention, on a display substrate, for example, a known photolithographic method may be employed. For example, the color filter may be produced according to a process comprising a step of uniformly applying the color composition of the invention onto a display support in a known method of a printing method, a spraying method, a bar coating method, a roll coating method, a spin coating method or the like, a step of removing the solvent from the ink by heating, a step of exposing the coating film on the display substrate to light from a high-pressure mercury lamp, an alkali development step, a washing step and a baking step to thereby form a color filter pattern on the substrate.

### 2) Inkjet Method:

In case where the color filter of the invention is produced according to an inkjet method, the polymerizable compound to be in the color composition for color filter of the invention may be, with no specific limitation thereon, any one heretofore used in inkjet ink. Preferred is a monomer of photosensitive resin and/or thermosetting resin.

The photosensitive resin include acrylic resin, methacrylic resin, epoxy resin, etc.; and preferred are acrylic resin and methacrylic resin. For the acrylic resin and the methacrylic resin, preferred is a combination of a photo-polymerizable monomer selected from acrylate, methacrylate, urethane acrylate, urethane methacrylate, acrylic amide, methacrylic amide, alkyl acrylate, benzyl methacrylate, benzyl acrylate, aminoalkyl methacrylate and the like, and a photopolymerization initiator selected from benzophenone derivative, acetophenone derivative, benzoin derivative, benzoin ether derivative, thioxanthone derivative, anthraquinone derivative, naphthoquinone derivative, triazine derivative and the like. In addition to the above-mentioned photo-polymerizable monomer, any other photo-polymerizable monomer having a hydrophilic group such as acrylic acid, methacrylic cid, maleic acid, vinyl acetate or the like may be added to the composition.

The thermosetting resin includes, for example, melamine resin, urea resin, alkyd resin, epoxy resin, phenolic resin, cyclopentadiene resin, etc.

In the inkjet method, the solvent to be in the color composition may be any of an oily medium or an aqueous medium, but preferred is an aqueous medium. As the aqueous medium, water, or a mixed solvent of water and a water-soluble organic solvent may be used, but preferred is a mixed solvent of water and water-soluble organic solvent. Also preferably, the solvent is a deionized one.

The oily solvent for use in the color composition is not specifically defined. For example, usable are those mentioned hereinabove for the solvent for the color composition for photolithography.

The solvent to be in the aqueous medium may be selected from alcohols, ketones, ethers, glycols, glycerin, alkylene glycol monoalkyl ethers, alkylene glycol dialkyl ethers, alkanolamines, nitrogen-containing polar organic solvents and the like that are soluble in water. One or more such water-soluble organic solvents may be used herein either singly or as combined.

Not specifically defined, the amount of the solvent to be used may be suitably so controlled that the viscosity of the color composition at room temperature could be at most 20 mPa·s, preferably at most 10 mPa·s.

The color composition of the invention may be prepared according to a method comprising a step of dispersing and mixing the constitutive ingredients, like the color composition for photolithography. In dispersion, if desired, a dispersant may be incorporated in the composition, like in that for photolithography.

In addition to the above-mentioned ingredients, if desired, the color composition of the invention may contain various known additives such as wetting agent, antifading agent, emulsion stabilizer, UV absorbent, preservative, antifungal agent, pH controlling agent, surface tension controlling agent, defoaming agent, viscosity controlling agent, dispersion stabilizer, etc.

Not specifically defined, the method for forming a color filter by the use of the color composition prepared in the manner as above may be any method of forming a color filter according to a known inkjet process. For example, a color filter may be produced according to a method comprising a step of forming a predetermined color filter pattern with liquid droplets on a display substrate, a step of drying it, and a step of curing the color filter pattern on the substrate through heat treatment or photoirradiation or through both the two, thereby forming a coating film on the substrate.

The photolithographic method and the inkjet method are described in the above; however, the color filter of the invention may be produced in any other method than the two.

In a case of using any other color filter formation method than the above (for example, various printing methods such as offset printing method), the color composition for color filter and the obtained color filter are all within the scope of the invention so far as the color composition contains the above-mentioned polymerizable compound and solvent and contains an azo compound of formula (1) as the colorant therein.

For example, the ingredients of the polymerizable compound, the solvent and the additives, as well as the formulations in forming the color filter may be suitably selected in accordance with conventional cases, and should not be limited to those described in the above-mentioned photolithographic method and inkjet method.

The color filter of the invention produced in the manner as above forms a pixel along with G (green) and B (blue) color filters according to a known method. The filter has an extremely high transparency and excellent spectral characteristics and has a small extinction polarization effect, and therefore gives a liquid-crystal display capable of displaying sharp images.

### [Color Filter]

For forming a color filter, there are known a method of first forming a pattern with a photoresist followed by dying it; and a method of forming a pattern with a dye-added photoresist, as disclosed in JP-A 4-163552, 4-128703, 4-175753. As the method for introducing the colorant to the color filter in the invention, any of such methods is employable, but preferred is a method of forming a color filter that comprises applying a positive resist composition containing a thermosetting resin, a quinonediazide compound, a crosslinking agent, a colorant and a solvent onto a substrate, then exposing it via a mask, developing the exposed area to form a positive resist pattern, further exposing the positive resist pattern in a mode of entire surface exposure, and thereafter curing the exposed positive resist pattern, as in JP-A 4-175753 and JP-A 6-35182. A black matrix may be formed according to a known method, and an RGB primary color filter or an M-Y-C complementary color filter may be produced. In the color filter, the amount of the azo pigment of the invention to be used is not defined, but is preferably from 0.1 to 50% by mass.

Regarding the thermosetting resin, the quinonediazide compound, the crosslinking agent and the solvent and their amounts, referred to are the disclosures in the above-mentioned patent publications, and those disclosed in the publications are preferably employed herein.

### [Examples]

The invention is described more concretely with reference to the following Examples. The materials, the reagents, their proportions, the instruments and their operation may be suitably changed and modified, not overstepping the scope and the sprit of the invention. Accordingly, the scope of the invention should not be limited to the specific examples given below. Unless otherwise specifically indicated, "%" and "part" in the following Examples are "% by mass" and "part by mass"; and the molecular weight is mass-average molecular weight.

### [Production Example 1] Production of Pig.-8

A production scheme for Pig.-8 is shown below.

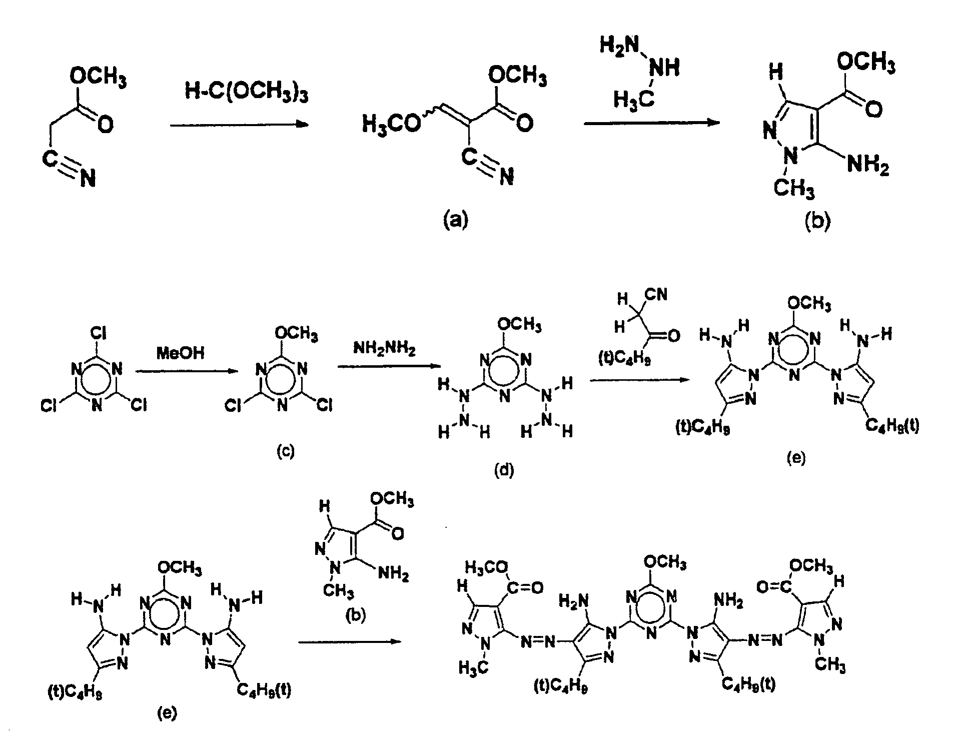

### (1) Production of Intermediate (a):

42.4 g (0.4 mols) of trimethyl orthoformate, 20.4 g (0.2 mols) of acetic anhydride and 0.5 g of p-toluenesulfonic acid were added to 29.7 g (0.3 mols) of methyl cyanoacetate, and heated at 110°C (outside temperature), and stirred for 20 hours with removing the low-boiling-point ingredient from the reaction system through evaporation. The reaction liquid was concentrated under reduced pressure, and purified through a silica gel column to give 14.1 g the above-mentioned intermediate (a) (yellow powder, yield 30%). The NMR data of the obtained intermediate (a) are as follows:
¹H-NMR (300 MHz, CDCl₃): 7.96 (s, 1H), 4.15 (s, 3H), 3.81 (s, 3H)

### (2) Production of Intermediate (b):

150 mL of isopropanol was added to 7.4 mL (141 mmols) of methylhydrazine, and cooled at 15°C (inside temperature). 7.0 g (49.6 mmol) of the intermediate (a) was gradually added to the mixture liquid, then heated at 50°C and stirred for 1 hour and 40 minutes. The reaction liquid was concentrated under reduced pressure, and purified through a silica gel column to give 10.5 g the above-mentioned intermediate (b) (white powder, yield 50%). The NMR data of the obtained intermediate (b) are as follows:
¹H-NMR (300 MHz, CDCl₃): 7.60 (s, 1H), 4.95 (brs, 2H), 3.80 (s, 3H), 3.60 (s, 3H)

### (3) Production of Intermediate (c):

136 mL of water was added to 1.1 L of methanol, then 182 g (2.17 mols) of sodium hydrogencarbonate was added thereto and stirred at room temperature. At the temperature, 200 g (1.08 mols) of cyanuric chloride was portionwise added thereto. After the addition, the inside temperature was elevated up to 30°C. At the temperature, this was stirred for 30 minutes, then 500 mL of water was added thereto, and the precipitated solid was taken out through filtration, washed with 500 mL of water and 300 mL of methanol poured thereto, and dried to give 168 g of the above-mentioned intermediate (c) (white powder, yield 86.2%). The NMR data of the obtained intermediate (c) are as follows:
¹H-NMR (300 MHz, CDCl₃): 4.14 (s, 3H)

### (4) Production of Intermediate (d):

673 mL of water was added to 363 mL (7.46 mols) of hydrazine monohydrate, cooled at 10°C (inside temperature), and 168 g (934 mmols) of the intermediate (c) was gradually added to the mixture liquid (at inside temperature of not higher than 20°C), then the ice bath was removed, and this was restored to room temperature and stirred at the temperature for 30 minutes. The crystal precipitated out from the reaction liquid was taken out through filtration, washed with 700 mL of water and 1 L of acetonitrile poured thereto, and dried to give a crude product (white powder) of the above-mentioned intermediate (d).

### (5) Production of Intermediate (e):

480 mL of ethylene glycol was added to the crude product of the intermediate (d), and stirred at room temperature. 257 g (2.06 mols) of pivaloylacetonitrile was added to the suspension, and heated so that the inside temperature could reach 50°C. At the temperature, 12 M hydrochloric acid was dropwise added thereto so that the mixture could have a pH of 3, and then this was heated up to 80°C (inside temperature), and stirred for 3 hours. After the reaction, this was cooled with ice until the inside temperature could reach 8°C, and the crystal thus precipitated out was taken out through filtration, washed with water poured thereto, and purified through a silica gel column to give 105 g of the above-mentioned intermediate (e) (white powder, yield in the two steps, 29.2 %). The NMR data of the obtained intermediate (e) are as follows:
¹H-NMR (300 MHz, d-DMSO): 7.00 (s, 4H), 5.35 (s, 2H), 4.05 (s, 3H), 5.35 (s, 2H), 1.22 (s, 18H)

### (6) Production of Azo Pigment (1):

A mixture liquid of 125 mL of acetic acid and 24 mL of sulfuric acid was cooled with ice to 3°C (inside temperature). At the temperature, 26.4 g of nitrosyl sulfuric acid was added to it, and then at the temperature, 11.6 g of the intermediate (b) was portionwise added thereto and dissolved. At the temperature, this was stirred for 1 hour, then at the temperature, 1.2 g of urea was portionwise added thereto, and stirred for 15 minutes at the temperature to give a diazonium salt solution. Apart from this, 11.6 g of the intermediate (e) was completely dissolved in 405 mL of methanol at room temperature, and cooled with ice to -3°C (inside temperature). At the temperature, the above-mentioned diazonium salt solution was portionwise added thereto so that the inside temperature could be not higher than 3°C, and after the addition, this was stirred for 2 hours. The ice bath was removed, then the mixture was stirred at room temperature for 10 minutes, and the precipitated crystal was taken out through filtration, washed with 150 mL of methanol poured thereto, and further with 100 mL of water poured thereto. Not dried, the obtained crystal was suspended in 750 mL of water, then aqueous 8 N potassium hydroxide solution was added thereto to make it have a pH of 5.7. This was stirred at room temperature for 20 minutes, then the formed crystal was collected through filtration, fully washed with water poured thereto, and then with 80 mL of methanol poured thereto. The obtained crystal was dried at room temperature for 12 hours.

The obtained crystal was suspended in a mixed solution of 180 mL of dimethylacetamide and 180 mL of water, then heated up to 85°C (inside temperature), and stirred at the temperature for 2 hours. Subsequently, the formed crystal was collected through filtration while hot, then suspended in 300 mL of methanol, and stirred at room temperature for 30 minutes. The formed crystal was collected through filtration, and dried at room temperature for 5 hours to give 19.5 g of the azo pigment (1). Yield, 90.3%.

The obtained azo pigment (1) was visually observed with a transmission microscope (JEOL's electronic microscope, JEM-1010), and the length in the long axis direction of the primary particles was about 150 nm.

The azo pigment (1) was analyzed for X-ray diffractiometry under the condition mentioned in the above, and this gave characteristic X-ray diffraction peaks at Bragg angles (2θ ± 0.2°) of 7.2° and 25.9°.

Fig. 1 shows the CuKα characteristic X-ray diffraction pattern of the azo pigment (1).

### [Example 1]

A production method for a color filter is demonstrated, in which a positive resist composition comprising a thermosetting resin, a quinonediazide compound, a crosslinking agent, a colorant (coloring agent) and a solvent is applied onto a silicon wafer according to a spin-coating method, then the solvent is evaporated away by heating, and the wafer is exposed to light via a mask to thereby decompose the quinonediazide compound. This is optionally heated and then developed to form a mosaic pattern. For the photoexposure, used was Hitachi's i-ray exposure stepper HITACHI LD-5010-i (NA = 0.40). The developer was Sumitomo Chemical's SOPD or SOPS-B.

### <Preparation of Positive Resist Composition>

3.4 parts by mass of cresol-novolak resin (polystyrene-equivalent mass-average molecular weight, 4300) obtained from a mixture of m-cresol/p-cresol/formaldehyde (ratio by mol in reaction = 5/5/7.5), 1.8 parts by mass of o-naphthoquinonediazide-5-sulfonate ester (with two hydroxyl groups esterified on average) prepared by the use of a phenol compound shown by the following formula, 0.8 parts by mass of hexamethoxymethylolated melamine, 20 parts by mass of ethyl lactate and 1 part by mass of an azo pigment (Pig.-8 shown above) were mixed to prepare a positive resist composition (color composition for color filter).

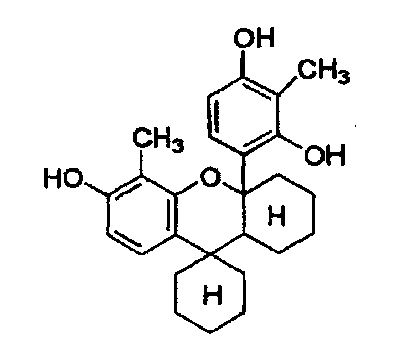

### <Production of Color Filter>

The obtained positive resist composition was applied onto a silicon wafer according to a spin coating method, and the solvent was evaporated away. The silicone wafer was exposed to light, then heated at 100°C, and developed with alkali to remove the exposed part, thereby forming a positive color pattern having a resolution of 0.8 µm. This was exposed to light on the entire surface thereof, and then heated at 150°C for 15 minutes to give a complementary yellow color filter.

### <Comparative Example>

A positive resist composition was prepared in the same manner as in Example 1, for which, however, Sumitomo Chemical's Oleosol Yellow 2G (1 part by mass) was used in place of the azo pigment of the invention used in Example 1. The positive resist composition was applied onto a silicon wafer according to a spin coating method, and the solvent was evaporated away. The silicone wafer was exposed to light, and developed with alkali to thereby form a positive color pattern having a resolution of 1 µm. This was exposed to light on the entire surface thereof, and then heated at 150°C for 10 minutes to give a yellow color filter.

### <Evaluation>

The transmission spectrum of each of the yellow color filters obtained above was measured, and the state of the spectrum on the short wave side and the long wave side (sharp cut), which is important in terms of color reproduction, was relatively evaluated as absorption property. A indicates that the state is good, B indicates that the state is still acceptable, and C indicates that the state is unacceptable. Further, the yellow color filters were irradiated with a xenon light (85000 Lux) for 7 days using a weather meter (ATLAS C. 165). The image density before and after irradiation with xenon was measured, and the color filters were evaluated based on the color retention as lightfastness.

**Table 1**

| | Colorant (coloring agent) | Absorption Property | Lightfastness |
|---|---|---|---|
| Example of the invention | Pig.-8 | A | 98% |
| Comparative Example | Oleosol Yellow 2G | B | 59% |

It is known that, as compared with the comparative color filter, the color filter comprising the specific pigment of the invention is excellent in color reproducibility in that the transmission spectrum is sharp both on the short wave side and on the long wave side. In addition, it is also known that, as compared with the comparative compound, the specific pigment in the invention is excellent in lightfastness.

### [Example 2]

A green color filer was produced in the same manner as in Example 1, for which, however, the positive resist composition was prepared using 0.4 parts by mass of the azo pigment (Pig.-8) and 0.6 parts by mass of C.I. Pigment Green 36 (Toyo Ink's Lionol Green 6YK), totaling 1 part by mass, in place of the azo pigment (Pig.-8) of the invention used in Example 1. The transmission spectrum of the green color filter was measured. This was characterized by the absorbance in the region of from 500 nm to 600 nm. It was confirmed that the color filter can realize an excellent spectral characteristic in the green reproduction region.

### [Example 3]

A red color filer was produced in the same manner as in Example 1, for which, however, 0.64 parts by mass of C.I. Pigment Red 254 (Ciba Japan's Irgaphor Red B-CF), 0.27 parts by mass of C.I. Pigment Red 177 (Ciba Japan's Chromophthal Red A2B) and 0.09 parts by mass of the azo pigment (Pig.-8) were used in place of 1 part by mass of the azo pigment (Pig.-8) used in Example 1. The transmission spectrum of the red color filter was measured. This was characterized by the absorbance in the long wavelength region. It was confirmed that the color filter can realize an excellent spectral characteristic in the red reproduction region.

Accordingly, the pigment dispersion comprising the azo pigment of the invention is favorable for color filters, for example, for displays such as LCD and PDP, and for imaging devices such as CCD.

According to the invention, there are provided a color composition for color filter excellent in dispersibility, dispersion temporal stability, heat resistance and lightfastness and capable of giving color filters of attaining high contrast and excellent transparency that are required by liquid-crystal color displays in various applications, and a method for preparing the color composition.

According to the invention, there is obtained a color filter attaining high contrast and excellent transparency required by liquid-crystal color displays in various applications.

The entire disclosure of each and every foreign patent application from which the benefit of foreign priority has been claimed in the present application is incorporated herein by reference, as if fully set forth.

## Claims

1. A color composition for color filter, comprising:
at least one of an azo pigment represented by formula (1), a tautomer of the azo pigment, and salts or hydrates thereof: 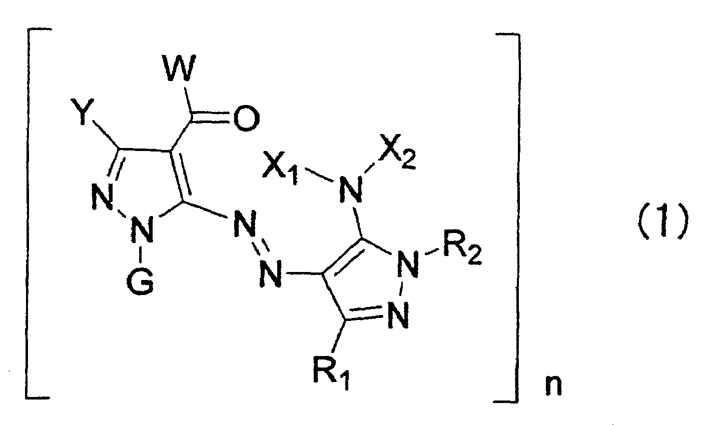
wherein Y represents a hydrogen atom or a substituent;
W represents an alkoxy group, an amino group, an alkyl group or an aryl group;
G represents a hydrogen atom, an alkyl group, a cycloalkyl group, an aralkyl group, an alkenyl group, an alkynyl group, an aryl group or a heterocyclic group;
X₁ and X₂ each independently represents a hydrogen atom, an alkyl group, an acyl group, an alkylsulfonyl group or an arylsulfonyl group;
R₁ represents a hydrogen atom or a substituent;
R₂ represents a heterocyclic group;
n represents an integer of from 1 to 4; and
when n = 2, the formula (1) represents a dimer via G, W, X₁, X₂, R₁ or R₂; when n = 3, the formula (1) represents a trimer via G, W, X₁, X₂, R₁ or R₂; and when n = 4, the formula (1) represents a tetramer via G, W, X₁, X₂, R₁ or R₂.

2. The color composition for color filter according to claim 1,
wherein n in the formula (1) is 2.

3. The color composition for color filter according to claim 1 or 2,
wherein at least one of X₁ and X₂ in the formula (1) is a hydrogen atom.

4. The color composition for color filter according to any of claims 1 to 3,
wherein the azo pigment represented by the formula (1) is an azo pigment represented by formula (2): 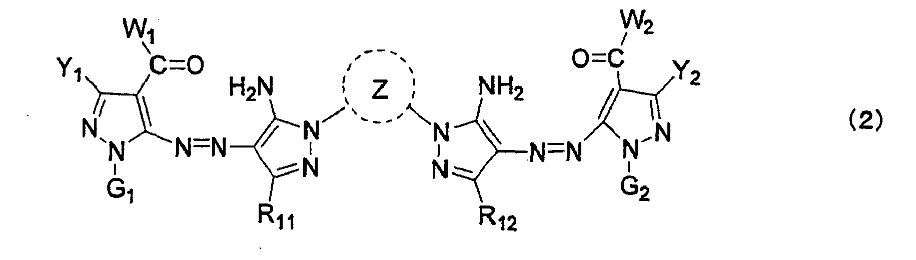 wherein Z represents a 5- to 8-membered nitrogen-containing hetero ring;
Y₁, Y₂, R₁₁ and R₁₂ each independently represents a hydrogen atom or a substituent;
G₁ and G₂ each independently represents a hydrogen atom, a cycloalkyl group, an alkyl group, an aralkyl group, an alkenyl group, an alkynyl group, an aryl group or a heterocyclic group;
W₁ and W₂ each independently represents an alkoxy group, an amino group, an alkyl group or an aryl group.

5. The color composition for color filter according to any of claims 1 to 4,
wherein W, W₁ and W₂ each independently represents an alkoxy group having a total carbon number of at most 3, an amino group, or an alkylamino group having a total carbon number of at most 3.

6. The color composition for color filter according to any of claims 1 to 5,
wherein G, G₁ and G₂ each independently represents an alkyl group having a total carbon number of at most 3.

7. The color composition for color filter according to any of claims 4 to 6,
wherein Z is a 6-membered nitrogen-containing hetero ring.

8. The color composition for color filter according to any of claims 1 to 4,
wherein the azo pigment represented by the formula (1) or formula (2) is an azo pigment represented by formula (3): 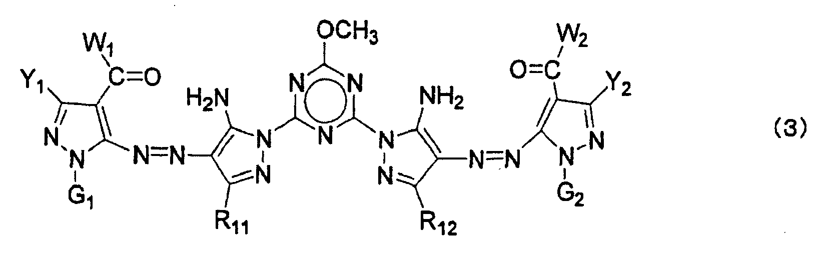 wherein Y₁, Y₂, R₁₁ and R₁₂ each independently represents a hydrogen atom or a substituent;
G₁ and G₂ each independently represents a hydrogen atom, a cycloalkyl group, an alkyl group, an aralkyl group, an alkenyl group, an alkynyl group, an aryl group or a heterocyclic group;
W₁ and W₂ each independently represents an alkoxy group, an amino group, an alkyl group or an aryl group.

9. The color composition for color filter according to any of claims 1 to 8,
wherein the azo pigment represented by the formula (1), formula (2) or formula (3) is an azo pigment which has a crystalline morphology and which is represented by formula (4):

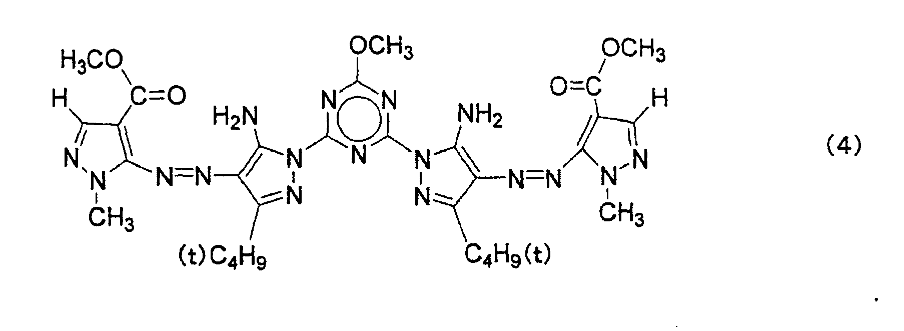

10. The color composition for color filter according to claim 9, which comprises a colorant selected from the group consisting of the azo pigment represented by the formula (4) and tautomers thereof,
wherein the colorant shows characteristic X-ray diffraction peaks at Bragg angles (2θ ± 0.2°) of 7.2° and 25.9° in CuKα characteristic X-ray diffractometry.

11. The color composition for color filter according to any of claims 1 to 10, further comprising:
a polymerizable compound; and
a solvent.

12. The color composition for color filter according to claim 11, which contains the azo pigment represented by the formula (1) in an amount of from 0.01 to 2 parts by mass relative to 1 part by mass of the polymerizable compound.

13. The color composition for color filter according to claim 11 or 12,
wherein the polymerizable compound is a photosensitive compound.

14. The color composition for color filter according to any of claims 1 to 13, further comprising:
one or more dispersants selected from a surfactant, a silicone-type additive, a pigment-type additive, a silane coupling agent and a titanium coupling agent.

15. A color filter formed by using the color composition for color filter according to any of claims 1 to 14.

16. The color filer according to claim 15, which is formed by a photolithographic method or an inkjet method.

17. A method for preparing the color composition for color filter according to claim 14, the method comprising:
a step of obtaining a pigment dispersion by dispersing one or more dispersants selected from a surfactant, a silicone-type additive, a pigment-type additive, a silane coupling agent and a titanium coupling agent, and the azo pigment represented by the formula (1) in a part of a solvent; and
a step of mixing the pigment dispersion with a polymerizable compound and a remainder of the solvent.
